# EUROPEAN PATENT APPLICATION

(11) **EP 4 797 884 A1**
(43) Date of publication of application: **26.08.2026**
(21) Application number: 24892755.0
(22) Date of filing: 13.06.2024
(51) Int. Cl.: H05K 3/46

(54) **CIRCUIT BOARD, COMMUNICATION DEVICE, AND CHIP**

(30) Priority: 21.11.2023 CN 202311568114
(71) Applicant: HUAWEI TECHNOLOGIES CO., LTD., Shenzhen 518129 (CN)
(72) Inventor: CHENG, Liujun, Shenzhen, Guangdong 518129 (CN); CAI, Li, Shenzhen, Guangdong 518129 (CN); GAO, Feng, Shenzhen, Guangdong 518129 (CN); TIAN, Qingshan, Shenzhen, Guangdong 518129 (CN)
(74) Representative: Goddar, Heinz J.
(86) International application number: PCT/CN2024/098825
(87) International publication number: WO 2025/107590

(57) **Abstract**

Embodiments of this application provide a circuit board, a communication device, and a chip. The circuit board is configured to connect to an electronic component, and the circuit board is configured to suppress a coefficient of thermal expansion mismatch between the circuit board and the electronic component, thereby effectively reducing an insertion loss of the circuit board. In a direction perpendicular to a surface of the circuit board, the circuit board includes M sub-boards that are sequentially arranged, M is any integer not less than 2, and the M sub-boards include a first sub-board and a second sub-board. A coefficient of thermal expansion of the first sub-board is less than a coefficient of thermal expansion of the second sub-board, and a dielectric dissipation factor of the second sub-board is less than a dielectric dissipation factor of the first sub-board.

## Description

This application claims priority to Chinese Patent Application No. 202311568114.1, filed with the China National Intellectual Property Administration on November 21, 2023 and entitled "CIRCUIT BOARD, COMMUNICATION DEVICE, AND CHIP", which is incorporated herein by reference in its entirety.

### TECHNICAL FIELD

This application relates to the field of communication technologies, and in particular, to a circuit board, a communication device, and a chip.

### BACKGROUND

A communication device includes a circuit board and an electronic component connected to a surface of the circuit board. To improve reliability of the communication device and reliability of an electrical connection of the circuit board, a coefficient of thermal expansion (coefficient of thermal expansion, CTE) mismatch between the circuit board and the electronic component needs to be suppressed.

An existing circuit board includes a first sub-board and a plurality of second sub-boards, and the first sub-board is located between the plurality of second sub-boards. To suppress the CTE mismatch, a CTE of the first sub-board is less than a CTE of the second sub-board.

However, when the CTE of the first sub-board is reduced, an insertion loss of the first sub-board is increased, and consequently, an insertion loss of the circuit board cannot be suppressed. A circuit board with a high insertion loss cannot meet a requirement for an increasingly high information transmission rate.

### SUMMARY

Embodiments of this application provide a circuit board, a communication device, and a chip. The circuit board is configured to connect to an electronic component, and the circuit board is configured to suppress a coefficient of thermal expansion mismatch between the circuit board and the electronic component, thereby effectively reducing an insertion loss of the circuit board.

A first aspect of this application provides a circuit board. The circuit board is configured to connect to an electronic component, and in a direction perpendicular to a surface of the circuit board, the circuit board includes M sub-boards that are sequentially arranged, M is any integer not less than 2, and the M sub-boards include a first sub-board and a second sub-board. In the M sub-boards, in the direction perpendicular to the surface of the circuit board, the first sub-board and the second sub-board are adjacent to each other, or the first sub-board and the second sub-board are spaced by at least one sub-board. Performance of a low coefficient of thermal expansion and performance of a low dielectric dissipation factor shown in this aspect are distributed to different sub-boards in the M sub-boards. Therefore, a coefficient of thermal expansion of the first sub-board is less than a coefficient of thermal expansion of the second sub-board, and a dielectric dissipation factor of the second sub-board is less than a dielectric dissipation factor of the first sub-board.

By using the circuit board shown in this aspect, when the coefficient of thermal expansion of the first sub-board is less than the coefficient of thermal expansion of the second sub-board, a coefficient of thermal expansion of the circuit board is effectively reduced. This effectively suppresses a coefficient of thermal expansion mismatch between the circuit board and the electronic component, ensures stability of an electrical connection of a communication device, and prolongs a service life of the communication device. When the dielectric dissipation factor of the second sub-board is less than the dielectric dissipation factor of the first sub-board, an insertion loss of the circuit board is effectively reduced. This makes the circuit board shown in this aspect meet both requirements for a low coefficient of thermal expansion and a low insertion loss.

Based on the first aspect, in an optional implementation, a Young's modulus of the second sub-board is less than a Young's modulus of the first sub-board.

In this implementation, due to the higher Young's modulus of the second sub-board, negative impact of the higher coefficient of thermal expansion of the second sub-board on the coefficient of thermal expansion of the entire circuit board can be reduced as much as possible. In addition, due to the lower Young's modulus of the second sub-board, a small via pitch of the circuit board is implemented.

Based on the first aspect, in an optional implementation, the M sub-boards include a plurality of second sub-boards, and the plurality of second sub-boards are symmetrically distributed by using the first sub-board as a center.

In this implementation, the plurality of second sub-boards are symmetrically distributed by using the first sub-board as a center, to improve flatness of the entire circuit board and warpage of the entire circuit board.

Based on the first aspect, in an optional implementation, the M sub-boards further include a third sub-board, and the second sub-board is located between the first sub-board and the second sub-board; and a coefficient of thermal expansion of the third sub-board is less than the coefficient of thermal expansion of the second sub-board, and the dielectric dissipation factor of the second sub-board is less than a dielectric dissipation factor of the third sub-board.

In this implementation, when the coefficient of thermal expansion of the third sub-board is less than the coefficient of thermal expansion of the second sub-board, the coefficient of thermal expansion of the circuit board is effectively reduced. This effectively suppresses a coefficient of thermal expansion mismatch of the circuit board, ensures stability of an electrical connection of a communication device, and prolongs a service life of the communication device. When the dielectric dissipation factor of the second sub-board is less than the dielectric dissipation factor of the third sub-board, an insertion loss of the circuit board is effectively reduced. This makes the circuit board shown in this aspect meet both requirements for a low coefficient of thermal expansion and a low insertion loss. In addition, because the second sub-board is located between the first sub-board and the third sub-board, reliability of the circuit board structure is improved.

Based on the first aspect, in an optional implementation, the Young's modulus of the second sub-board is less than a Young's modulus of the third sub-board.

In this implementation, in the circuit board, the third sub-board is located at an outermost layer. In this case, the Young's modulus of the third sub-board is greater than the Young's modulus of the second sub-board, thereby effectively improving rigidity of the entire circuit board and reducing an indentation on a surface of the circuit board during mounting.

Based on the first aspect, in an optional implementation, the M sub-boards include a plurality of third sub-boards, and the plurality of third sub-boards are symmetrically distributed by using the first sub-board as a center.

In this implementation, the plurality of third sub-boards are symmetrically distributed by using the first sub-board as a center, to improve flatness of the entire circuit board and warpage of the entire circuit board.

Based on the first aspect, in an optional implementation, in a target plane, the coefficient of thermal expansion of the first sub-board is less than the coefficient of thermal expansion of the second sub-board, and the coefficient of thermal expansion of the third sub-board is less than the coefficient of thermal expansion of the second sub-board, where the target plane is parallel to the surface of the circuit board.

In this implementation, in the target plane, the coefficient of thermal expansion of the first sub-board is less than the coefficient of thermal expansion of the second sub-board, and in the target plane, the coefficient of thermal expansion of the third sub-board is less than the coefficient of thermal expansion of the second sub-board. This effectively suppresses a coefficient of thermal expansion mismatch between the circuit board and the electronic component.

Based on the first aspect, in an optional implementation, a thickness of the first sub-board in a target direction is greater than a thickness of the second sub-board in the target direction, and the thickness of the first sub-board in the target direction is greater than a thickness of the third sub-board in the target direction, where the target direction is a direction perpendicular to the surface of the circuit board.

In this implementation, because the thickness of the first sub-board is greater than the thickness of the second sub-board and is greater than the thickness of the third sub-board, the coefficient of thermal expansion of the circuit board is effectively reduced. In addition, due to the smaller thickness of the second sub-board, negative impact of the second sub-board on a coefficient of thermal expansion of the entire circuit board can be reduced, and a thickness of the entire circuit board can be reduced.

Based on the first aspect, in an optional implementation, the M sub-boards include a fourth sub-board, and in the direction perpendicular to the surface of the circuit board, the fourth sub-board is located between the first sub-board and the second sub-board; and a coefficient of thermal expansion of the fourth sub-board is less than the coefficient of thermal expansion of the second sub-board, and the dielectric dissipation factor of the second sub-board is less than a dielectric dissipation factor of the fourth sub-board.

In this implementation, when the coefficient of thermal expansion of the fourth sub-board is less than the coefficient of thermal expansion of the second sub-board, the coefficient of thermal expansion of the circuit board is effectively reduced. This effectively suppresses a coefficient of thermal expansion mismatch of the circuit board, ensures stability of an electrical connection of a communication device, and prolongs a service life of the communication device. When the dielectric dissipation factor of the second sub-board is less than the dielectric dissipation factor of the fourth sub-board, an insertion loss of the circuit board is effectively reduced. This makes the circuit board shown in this aspect meet both requirements for a low coefficient of thermal expansion and a low insertion loss.

Based on the first aspect, in an optional implementation, the Young's modulus of the second sub-board is less than a Young's modulus of the fourth sub-board.

In this implementation, due to the higher Young's modulus of the second sub-board, negative impact of the higher coefficient of thermal expansion of the second sub-board on the coefficient of thermal expansion of the entire circuit board can be reduced as much as possible. In addition, due to the lower Young's modulus of the second sub-board, a small via pitch of the circuit board is implemented.

Based on the first aspect, in an optional implementation, the second sub-board includes a first dielectric layer, the coefficient of thermal expansion of the first sub-board is less than a coefficient of thermal expansion of the first dielectric layer, and a dielectric dissipation factor of the first dielectric layer is less than the dielectric dissipation factor of the first sub-board; and the second sub-board further includes a second dielectric layer, where in the direction perpendicular to the surface of the circuit board, the first dielectric layer includes a first surface and a second surface that are opposite to each other, the second dielectric layer is located on the first surface, and/or the second dielectric layer is located on the second surface, and a dielectric material of the second dielectric layer is different from a dielectric material of the first dielectric layer.

In this implementation, the coefficient of thermal expansion and the insertion loss of the circuit board can be effectively reduced.

Based on the first aspect, in an optional implementation, the first dielectric layer and the second dielectric layer satisfy at least one of the following conditions:
a dielectric dissipation factor of the second dielectric layer is less than the dielectric dissipation factor of the first dielectric layer, a Young's modulus of the second dielectric layer is greater than a Young's modulus of the first dielectric layer, and a coefficient of thermal expansion of the second dielectric layer is less than the coefficient of thermal expansion of the first dielectric layer.

In this implementation, the circuit board can meet both requirements for a low coefficient of thermal expansion and a low insertion loss.

Based on the first aspect, in an optional implementation, the third sub-board includes a first dielectric layer, the coefficient of thermal expansion of the first sub-board is less than a coefficient of thermal expansion of the first dielectric layer, and a dielectric dissipation factor of the first dielectric layer is less than the dielectric dissipation factor of the first sub-board; and the third sub-board further includes a second dielectric layer, where in the direction perpendicular to the surface of the circuit board, the first dielectric layer includes a first surface and a second surface that are opposite to each other, the second dielectric layer is located on the first surface, and/or the second dielectric layer is located on the second surface, and a dielectric material of the second dielectric layer is different from a dielectric material of the first dielectric layer.

In this implementation, the coefficient of thermal expansion and the insertion loss of the circuit board can be effectively reduced.

Based on the first aspect, in an optional implementation, the first dielectric layer and the second dielectric layer satisfy at least one of the following conditions:
a dielectric dissipation factor of the second dielectric layer is less than the dielectric dissipation factor of the first dielectric layer, a Young's modulus of the second dielectric layer is greater than a Young's modulus of the first dielectric layer, and a coefficient of thermal expansion of the second dielectric layer is less than the coefficient of thermal expansion of the first dielectric layer.

In this implementation, the circuit board can meet both requirements for a low coefficient of thermal expansion and a low insertion loss.

Based on the first aspect, in an optional implementation, the first sub-board includes a first dielectric layer, the coefficient of thermal expansion of the first sub-board is less than a coefficient of thermal expansion of the first dielectric layer, and a dielectric dissipation factor of the first dielectric layer is less than the dielectric dissipation factor of the first sub-board; and the first sub-board further includes a second dielectric layer, where in the direction perpendicular to the surface of the circuit board, the first dielectric layer includes a first surface and a second surface that are opposite to each other, the second dielectric layer is located on the first surface, and/or the second dielectric layer is located on the second surface, and a dielectric material of the second dielectric layer is different from a dielectric material of the first dielectric layer.

In this implementation, the coefficient of thermal expansion and the insertion loss of the circuit board can be effectively reduced.

Based on the first aspect, in an optional implementation, the first dielectric layer and the second dielectric layer satisfy at least one of the following conditions:
a dielectric dissipation factor of the second dielectric layer is less than the dielectric dissipation factor of the first dielectric layer, a Young's modulus of the second dielectric layer is greater than a Young's modulus of the first dielectric layer, and a coefficient of thermal expansion of the second dielectric layer is less than the coefficient of thermal expansion of the first dielectric layer.

In this implementation, the circuit board can meet both requirements for a low coefficient of thermal expansion and a low insertion loss.

Based on the first aspect, in an optional implementation, the first sub-board or the third sub-board is used as a power layer or a ground wire layer, and the second sub-board is used as a signal layer.

According to a second aspect, an embodiment of this application provides a communication device. The communication device includes a circuit board and an electronic component connected to the circuit board, where the circuit board is as described in any implementation of the first aspect. For descriptions of beneficial effects of the circuit board in this aspect, refer to the first aspect. Details are not described again.

According to a third aspect, an embodiment of this application provides a chip. The chip includes a package housing, the package housing includes a circuit board and a die connected to the circuit board, and the circuit board is as described in any implementation of the first aspect. For descriptions of beneficial effects of the circuit board in this aspect, refer to the first aspect. Details are not described again.

### BRIEF DESCRIPTION OF DRAWINGS

FIG. 1 is an example diagram of a structure of a communication device;
FIG. 2 is an example diagram of a structure of an existing circuit board;
FIG. 3 is an example diagram of a structure of a circuit board according to a first embodiment of this application;
FIG. 4 is an example diagram of a structure of a circuit board according to a second embodiment of this application;
FIG. 5 is an example diagram of another structure of an existing circuit board;
FIG. 6 is an example diagram of a structure of a circuit board according to a third embodiment of this application;
FIG. 7 is an example diagram of a structure of a circuit board according to a fourth embodiment of this application;
FIG. 8 is an example diagram of a structure of a circuit board according to a fifth embodiment of this application; and
FIG. 9 is an example diagram of a structure of a circuit board according to a sixth embodiment of this application.

### DESCRIPTION OF EMBODIMENTS

This application provides a communication device. The communication device includes a circuit board and an electronic component connected to a surface of the circuit board. The communication device provided in embodiments of this application can effectively suppress a CTE mismatch between the circuit board and the electronic component.

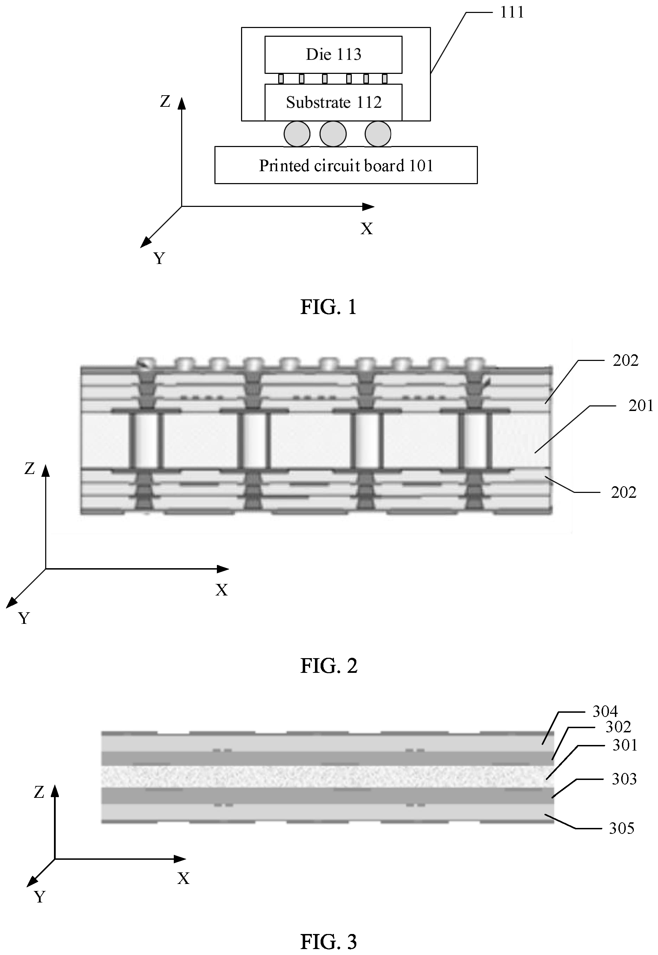

For example, FIG. 1 is an example diagram of a structure of the communication device. The communication device includes a printed circuit board (printed circuit board, PCB) 101. The communication device further includes an electronic component connected to a surface of the PCB 101, and the electronic component may be a chip. The chip specifically includes a package housing 111, and the package housing 111 includes a substrate (Substrate) 112 and a die (die) 113 connected to a surface of the substrate 112. The substrate 112 is connected to the surface of the PCB 101 through ball grid array (ball grid array, BGA) packaging. In this embodiment, an example in which a type of a circuit board included in the package housing 111 of the chip is a substrate is used. In another example, a type of a circuit board included in the package housing 111 may alternatively be a PCB. In this case, the die 113 is connected to a surface of the PCB. In the example shown in FIG. 1, an example in which the electronic component connected to the surface of the PCB 101 is a chip is used. In another example, the electronic component packaged on the surface of the PCB 101 may be any type of electronic component, for example, a resistor, a capacitor, an inductor, a connector, a laser device, a power supply, or the like, and the electronic component may alternatively be a die. This means that the die is directly connected to the surface of the PCB 101. A type of a device to which the communication device is used is not limited in this example. For example, the communication device may be used in an optical transmission device, an optical access device, a router, a switch, a wireless base station, a wireless remote access device, a wireless baseband signal processing device, or the like, or may be a compute server (generally referred to as a server), a high-performance computer (high-performance computer, HPC), a storage server, a memory resource pool, or the like. The device to which the communication device is used may alternatively be various types of terminal devices, for example, a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a compute device, another processing device connected to a wireless modem, a vehicle-mounted device, a wearable device, or any communication network, for example, a terminal device in a 5th generation mobile communication technology (5th generation mobile communication technology, 5G), a terminal device in a 6th generation mobile communication technology (6th generation mobile networks, 6G), or a terminal device in a future evolved public land mobile network (public land mobile network, PLMN). This is not specifically limited.

A target plane XY shown in this example means a direction parallel to the surface of the PCB 101, and a target direction Z is perpendicular to the target plane, in other words, the target direction Z is perpendicular to the surface of the PCB 101. In this example, the PCB 101 is electrically connected to the substrate 112 in the package housing 111 through solder ball or solder paste welding. In an assembly and welding process, because heating is required for the solder ball or solder paste welding, both the PCB 101 and the package housing 111 are changed in size due to heating. The PCB 101 has a first CTE in the target plane XY, and the package housing 111 has a second CTE in the target plane XY. A CTE mismatch of the communication device means that there is a large difference between the first CTE and the second CTE. When a CTE mismatch occurs in the communication device, the PCB 101 and the package housing 111 are deformed inconsistently in a temperature rise and fall process. As a result, when the temperature is restored to a room temperature, there is an internal stress at a position of a solder joint between the PCB 101 and the package housing 111. A larger difference between the first CTE of the PCB 101 and the second CTE of the package housing 111 indicates a larger internal stress. When the internal stress exceeds a connection force at the solder joint, problems such as cracking of the solder joint occur, and consequently, an electrical connection between the PCB 101 and the package housing 111 fails. In addition, in an actual use process of the communication device, if there is a large CTE difference between the PCB 101 and the package housing 111, the solder joint is also subject to a thermal fatigue stress (which may also be referred to as creep fatigue) for a long periodicity due to factors such as an ambient temperature change or heat generation during use of the communication device, and finally, the solder joint is cracked and fails. Especially, when there is a large cyclic fluctuation in an ambient temperature and the communication device is repeatedly powered on and off, there is a cyclic stress at the solder joint, resulting in an electrical connection failure and affecting a service life of the communication device. In this example, there is also a CTE mismatch problem between the substrate 112 and the die 113. For a specific description, refer to the descriptions of the CTE mismatch between the PCB 101 and the package housing 111. Details are not described again.

Therefore, if the CTE mismatch of the communication device can be effectively suppressed, the stability of the electrical connection of the communication device can be effectively ensured, and the service life of the communication device can be prolonged. The CTE mismatch between the PCB 101 and the package housing 111 is used as an example. A dielectric material used to prepare the PCB 101 includes a polymer resin, a filler, a fiber cloth, and the like. A CTE of the polymer resin is usually greater than 50 parts per million/degree Celsius (ppm/°C). The package housing 111 is generally made of inorganic materials such as ceramic and silicon. Therefore, a CTE of the PCB 101 in the target plane XY is greater than a CTE of the package housing 111 in the target plane XY. Generally, the CTE of the package housing 111 in the target plane XY approximately ranges from 2 ppm/°C to 10 ppm/°C, and a CTE of a dielectric material of the PCB 101 in the target plane XY generally ranges from 15 ppm/°C to 25 ppm/°C. Therefore, to suppress the CTE mismatch between the PCB 101 and the package housing 111, and to resolve a problem that the service life of the communication device is shortened due to cracking of the solder joint and an electrical connection failure caused by the CTE mismatch, the CTE of the dielectric material of the PCB 101 in the target plane XY may be reduced, to reduce the difference between the first CTE and the second CTE, and further suppress the CTE mismatch between the PCB 101 and the package housing 111. Similarly, to suppress the CTE mismatch between the substrate 112 and the die 113, the CTE of the substrate 112 in the target plane XY may also be reduced. For a specific description, refer to the descriptions of suppressing the CTE mismatch between the PCB 101 and the package housing 111. Details are not described again.

A structure of an existing circuit board is described in detail with reference to FIG. 2. FIG. 2 is an example diagram of the structure of the existing circuit board. As shown in FIG. 2, an example in which the circuit board is a flip chip ball grid array (flip chip ball grid array, FCBGA) package substrate is used. The circuit board includes a first sub-board 201. The first sub-board 201 is a copper-clad core (Core) with copper foil on both sides. The first sub-board 201 is located between two second sub-boards 202. The second sub-board 202 is a multi-layer ajinomoto build-up film (ajinomoto build-up film, ABF). Two adjacent second sub-boards 202 are electrically connected by depositing a copper layer (namely, a seed layer) using a semi-additive process (semi-additive process, SAP). A thickness of the first sub-board 201 shown in FIG. 2 in the target direction Z is greater than a thickness of each second sub-board 202. To reduce a CTE of the entire circuit board in the target plane XY, a CTE of the first sub-board 201 is less than a CTE of the second sub-board 202 in the target plane XY, thereby reducing the CTE of the entire circuit board in the target plane XY. The first sub-board 201 may be a copper-clad laminate (copper clad laminate, CCL) with copper foil on both sides. The CCL means that copper foil is clad on both sides of a dielectric material. The dielectric material generally includes a glass fiber, a polymer resin, a filler, and the like.

As a transmission rate of a communication device is increasingly high, a capacity of transmitted information is increasingly large, and a requirement for high-speed signal transmission performance of a circuit board is increasingly high. Therefore, the circuit board needs to have both performance of suppressing a CTE mismatch between the circuit board and an electronic component and performance of reducing an insertion loss (insertion loss). An example in which the circuit board is a PCB is used to describe how to reduce an insertion loss of the PCB in an existing solution.

The insertion loss of the PCB mainly includes a dielectric loss and a conductor loss of the dielectric material. The dielectric loss mainly depends on a dielectric dissipation factor (dissipation factor, Df), a dielectric constant (dielectric constant, Dk), and a frequency that are of the dielectric material. Lower Df and Dk of the dielectric material indicate better insertion loss performance of the PCB. It may be understood that, if the Df and Dk of the PCB can be effectively reduced, the insertion loss of the PCB can be effectively reduced.

To improve performance of the communication device, the PCB needs to be capable of suppressing the CTE mismatch between the PCB and the electronic component and reducing the insertion loss. To enable the PCB to suppress the CTE mismatch between the PCB and the electronic component and reduce the insertion loss, in the existing PCB shown in FIG. 2, a dielectric material used to prepare the first sub-board 201 needs to have both the performance of suppressing the CTE mismatch between the PCB and the electronic component and the performance of reducing the insertion loss. For example, the first sub-board 201 is a CCL. A CTE of the CCL is mainly affected by a polymer resin, a filler, a reinforcing material, and copper foil. For details, refer to the following formula 1: ${α}_{CCL} = \frac{{α}_{r} {K}_{r} {φ}_{r} + {α}_{f} {K}_{f} {φ}_{f} + {α}_{g} {K}_{g} {φ}_{g} + {α}_{c} {K}_{c} {φ}_{c}}{{K}_{r} {φ}_{r} + {K}_{f} {φ}_{f} + {K}_{g} {φ}_{g} + {K}_{c} {φ}_{c}}$

In formula 1, a_{CCL} is the CTE of the first sub-board 201, α is a coefficient of thermal expansion, K is a Young's modulus, and φ is a volume percentage. r is the polymer resin, f is the filler, g is the reinforcing material, and c is the copper foil. For example, aᵣ is a coefficient of thermal expansion of the polymer resin, Kᵣ is a Young's modulus of the polymer resin, and *φᵣ* is a volume percentage of the polymer resin.

Because copper foil used in the CCL is mostly electro-deposited copper foil or rolled annealed copper foil, purity of the copper foil is 99.5% or above. CTEs of different types of copper foil are similar, and are all approximately 17 ppm/°C. A main factor that affects the CTE of the CCL is the polymer resin, followed by the reinforcing material (for example, glass fiber cloth) and the filler. For the CTE of the dielectric material in the target plane XY, a CTE of the reinforcing material is a key influencing factor.

Similarly, main factors that affect the Df performance of the CCL are also the polymer resin, the reinforcing material, and the filler. Refer to the following formula 2:$Dfccl = VA ∗ DfA + VB ∗ DfB + VC ∗ DfC$

In formula 2, Dfccl is a Df of the CCL. V is a volume percentage, and A, B, and C represent different components. For example, VA is a volume percentage of the polymer resin, DfA is a Df of the polymer resin, VB is a volume percentage of the filler, DfB is a Df of the filler, VC is a volume percentage of the reinforcing material, and DfC is a Df of the reinforcing material.

However, it is difficult for the dielectric material of the first sub-board 201 to have both performance of a low insertion loss and a low CTE in the target plane XY. For example, it is assumed that the dielectric material used by the first sub-board 201 needs to have both a low insertion loss and a low CTE in the target plane XY, for example, for the first sub-board 201, the CTE in the target plane XY needs to be less than or equal to 10 ppm/°C, and a Df needs to be less than or equal to 0.002@10 gigahertz (GHz). A Df value of the first sub-board 201 is positively correlated with a loss of the circuit board. In other words, a smaller Df value of the circuit board indicates a smaller insertion loss of the circuit board. It may be understood that reducing the Df of the circuit board can reduce the insertion loss of the circuit board. However, it is difficult to reduce the CTE of the first sub-board 201 in the target plane XY while reducing the Df of the first sub-board 201. This is because a dielectric material with a low CTE in the target plane XY usually has a high Df, and a dielectric material with a low Df has a high CTE in the target plane XY. For example, to implement a low CTE of the first sub-board 201 in the target plane XY, the dielectric material of the first sub-board 201 may be a polymer resin with a low CTE. However, the polymer resin with the low CTE usually has a high Df, in other words, the polymer resin with the low CTE usually does not have performance of a low Df. If the dielectric material of the first sub-board 201 is made of a quartz cloth material, costs of the dielectric material are greatly increased and processing difficulty is greatly increased, and consequently, a small via pitch (pitch) cannot be implemented. To reduce the CTE of the first sub-board 201 in the target plane XY, a proportion of the fiber cloth may be increased in the dielectric material, so that the first sub-board 201 has both performance of a low CTE and a low insertion loss. However, the first sub-board 201 with an increased proportion of the fiber cloth may have a fiber cloth interface, and a conductive anodic filament (conductive anodic filament, CAF) failure between vias is very likely to occur. Especially when the via pitch is less than or equal to 200 µm, a proportion of a filler with performance of a low CTE and a low insertion loss affects impregnation performance of the interface. In addition, microcracks at the fiber cloth interface caused by drilling of high-density vias deteriorate CAF reliability, and a CAF failure is likely to occur. If the first sub-board 201 has a low CTE in the target plane XY, costs of the first sub-board 201 are greatly increased or processing difficulty is greatly increased (for example, the dielectric material of the first sub-board 201 is quartz cloth), and high filler filling or the like used to reduce the CTE of the first sub-board 201 in the target plane XY affects impregnation performance between the polymer resin and the filler and between the polymer resin and the glass fiber cloth. Consequently, problems such as deterioration of heat resistance, CAF resistance, and highly accelerated stress test (highly accelerated stress test, HAST) resistance of the via occur.

This application provides a communication device. The communication device includes a circuit board and an electronic component electrically connected to a surface of the circuit board. For descriptions of a type of the electronic component, refer to the descriptions corresponding to FIG. 1. Details are not described again. The circuit board of the communication device has both performance of a low insertion loss and performance of a low CTE. The circuit board shown in this embodiment can effectively suppress a CTE mismatch between the circuit board and the electronic component, improve reliability of the circuit board, and effectively reduce an insertion loss of the circuit board, thereby meeting a requirement that an information transmission rate of the circuit board is increasingly high. For example, for the circuit board provided in this embodiment, a CTE is less than or equal to 15 ppm/°C, and a Df is less than or equal to 0.002 @10 GHz.

FIG. 3 is an example diagram of a structure of a circuit board according to a first embodiment of this application. FIG. 3 shows the example diagram of the structure of the circuit board in a coordinate system XYZ. For descriptions of the coordinate system XYZ, refer to the descriptions corresponding to FIG. 1. Details are not described again. The circuit board shown in this embodiment includes M sub-boards sequentially arranged in a target direction Z, where M is any integer not less than 2. The M sub-boards specifically include one or more first sub-boards 301. A quantity of first sub-boards 301 is not limited in embodiments. In this embodiment, an example in which the circuit board includes one first sub-board 301 is used. The M sub-boards further include one or more second sub-boards. A quantity of second sub-boards is not limited in embodiments. In this embodiment, an example in which the circuit board includes a plurality of second sub-boards is used. For example, the plurality of second sub-boards are symmetrically distributed in a target direction Z by using the first sub-board 301 as a center. For example, the circuit board includes two second sub-boards, namely, a second sub-board 302 and a second sub-board 303. In the target direction Z, the first sub-board 301 is located between the second sub-board 302 and the second sub-board 303. The circuit board further includes a conductive layer (for example, copper foil shown in FIG. 2) located between the first sub-board 301 and the second sub-board 302. It should be noted that a quantity of second sub-boards included in the circuit board is not limited in embodiments. For example, if the circuit board includes four second sub-boards, two second sub-boards are stacked on an upper surface of the first sub-board 301, and two second sub-boards are stacked on a lower surface of the first sub-board 302. The circuit board shown in this example further includes a conductive layer located between two second sub-boards that are adjacent to each other. It should be noted that, in this embodiment, an example in which the plurality of second sub-boards are symmetrically distributed by using the first sub-board 301 as a center, to improve flatness of the entire circuit board and reliability of the structure of the circuit board is used. In another example, the plurality of second sub-boards may alternatively be asymmetrically distributed by using the first sub-board 301 as a center. A position relationship between the first sub-board 301 and the second sub-board is not limited in embodiments. In another example, a position relationship between the first sub-board and the second sub-board in the circuit board may be interchangeable. For example, the second sub-board is located between the plurality of first sub-boards.

The M sub-boards shown in this embodiment may further include one or more third sub-boards. A quantity of third sub-boards is not limited in embodiments. In this embodiment, an example in which the circuit board includes a plurality of third sub-boards is used. The plurality of third sub-boards are symmetrically distributed in the target direction Z by using the first sub-board 301 as a center, to improve flatness of the entire circuit board and reliability of the structure of the circuit board. For example, the circuit board includes two third sub-boards, namely, a third sub-board 304 and a third sub-board 305. In the target direction Z, the first sub-board 301, the second sub-board 302, and the second sub-board 303 are located between the third sub-board 304 and the third sub-board 305. In other words, the third sub-board 304 is connected to a surface that is of the second sub-board 302 and that is away from the first sub-board 301, and the third sub-board 305 is connected to a surface that is of the second sub-board 303 and that is away from the first sub-board 301. The circuit board further includes a conductive layer located between the second sub-board 302 and the third sub-board 304, and a conductive layer located between the second sub-board 303 and the third sub-board 305. It should be noted that a quantity of third sub-boards included in the circuit board is not limited in embodiments. For descriptions of a quantity and distribution forms of third sub-boards included in the circuit board, refer to the descriptions of a quantity and distribution forms of second sub-boards included in the circuit board. Details are not described again.

It can be learned from the foregoing description that, it is difficult for a same dielectric material to have both performance of a low CTE and a low Df. In this embodiment, to reduce a CTE and a Df of the entire circuit board, two pieces of performance of a low CTE and a low Df are distributed to different sub-boards included in the circuit board. In this embodiment, the first sub-board has the performance of a low CTE, and the second sub-board has the performance of a low Df. It may be understood that, in this embodiment, to suppress a CTE mismatch between the circuit board and an electronic component, a CTE of the circuit board needs to be reduced. A manner of reducing the CTE of the circuit board shown in this embodiment is to ensure that a CTE of the first sub-board 301 is less than a CTE of the second sub-board. Specifically, in a target XY plane, the CTE of the first sub-board 301 is less than the CTE of the second sub-board. A CTE of the third sub-board shown in this embodiment is less than the CTE of the second sub-board. Specifically, in the target XY plane, the CTE of the third sub-board is less than the CTE of the second sub-board. It should be noted that, in this embodiment, a CTE of each sub-board is a CTE in the target plane. In another example, the CTE of each sub-board may alternatively be a CTE of each sub-board in the target direction Z. This is not specifically limited in embodiments. It may be understood that the CTE of the second sub-board shown in this embodiment is the highest in the M sub-boards. A size relationship between the CTE of the first sub-board and the CTE of the third sub-board is not limited in embodiments.

When the CTE of the first sub-board and the CTE of the third sub-board in the M sub-boards included in the circuit board are respectively less than the CTE of the second sub-board, the CTE of the entire circuit board can be effectively reduced. For a specific description, refer to the following formula 3:

For example, the circuit board shown in this embodiment is a PCB. It should be noted that descriptions of a type of the circuit board are not limited in embodiments. For example, the circuit board may alternatively be a substrate. For the descriptions of the type of the circuit board, refer to the descriptions corresponding to FIG. 1. Details are not described again. A CTE of the PCB is affected by a dielectric material and a thickness that are used by the PCB. When a proportion of copper foil in the PCB is constant and a PCB design is fixed, a lower CTE of the dielectric material indicates a lower CTE of the PCB. The PCB design includes a via, a plug hole, a solder mask, a residual copper rate of a pattern, and the like. This is not specifically limited. The CTE of the PCB may be obtained by using formula 3: ${α}_{PCB} = \frac{{α}_{1} {E}_{1} {φ}_{1} + {α}_{2} {E}_{2} {φ}_{2} + {α}_{…} {E}_{…} {φ}_{…} + {α}_{n} {E}_{n} {φ}_{n}}{{E}_{1} {φ}_{1} + {E}_{2} {φ}_{2} + {E}_{…} {φ}_{…} + {E}_{n} {φ}_{n}}$

In formula 3, 1 to n are codes of sub-boards on the PCB. The PCB includes a sub-board 1, a sub-board 2, ..., and a sub-board n. αn is a CTE of the sub-board n, En is a Young's modulus of the sub-board n, and φn is a volume proportion of the sub-board n. It can be learned from the foregoing that, if the CTEs of the first sub-board 301 and the third sub-board are reduced, a CTE of the entire PCB can be effectively reduced. The CTE of the entire PCB is a_{PCB} in formula 3.

It can be learned from the foregoing description that, it is difficult for a sub-board to have both performance of a low CTE and a low insertion loss. However, in this embodiment, to enable the circuit board to have both performance of a low CTE and a low insertion loss, the performance of having a low CTE and the performance of having a low insertion loss are distributed to different sub-boards included in the circuit board. Specifically, when the CTE of the second sub-board is the highest in the M sub-boards, a Df of the second sub-board is the smallest in the M sub-boards, thereby reducing the CTE and the insertion loss of the entire circuit board. Therefore, to ensure that an insertion loss of the second sub-board is the lowest in the M sub-boards, the Df of the second sub-board is less than a Df of the first sub-board, and the Df of the second sub-board is less than a Df of the third sub-board. A size relationship between the Df of the first sub-board and the Df of the third sub-board is not limited in embodiments. It may be understood that, when the CTE of the second sub-board is the highest in the M sub-boards, and the Df of the second sub-board is the smallest in the M sub-boards, in this embodiment, the performance of a low CTE and the performance of a low insertion loss are respectively distributed to two different sub-boards, to be specific, the first sub-board and the third sub-board have the performance of a low CTE, and the second sub-board has the performance of a low insertion loss.

In this embodiment, to effectively reduce the CTE of the entire circuit board, a Young's modulus of the second sub-board is less than a Young's modulus of the first sub-board, and/or the Young's modulus of the second sub-board is less than a Young's modulus of the third sub-board. In this embodiment, an example in which the Young's modulus of the second sub-board is the lowest in the M sub-boards is used. In this case, due to a low Young's modulus of the second sub-board, negative impact of a high CTE of the second sub-board on the CTE of the entire circuit board can be reduced as much as possible. It can be learned from the foregoing formula 3 that, to reduce the CTE of the entire circuit board, when CTEs and volume proportions of the M circuit boards are constant, a lower Young's modulus of the second sub-board indicates a lower CTE of the entire circuit board. Optionally, in the circuit board shown in this embodiment, the third sub-board is located at an outermost layer. In this case, the Young's modulus of the third sub-board is the highest in the plurality of sub-boards included in the circuit board, thereby effectively improving rigidity of the entire circuit board and reducing an indentation on a surface of the circuit board during mounting. The following specifically describes each sub-board of the circuit board.

The first sub-board 301 may be used as a power layer (power layer) or a ground wire layer (ground layer) with a low electrical requirement. The power layer is disposed with a power supply and a ground wire, to ensure stable and reliable power supply of the entire circuit board. The ground wire layer is disposed with a ground wire and a power line, to ensure a stable and reliable ground wire connection of the entire circuit board. The Young's modulus of the first sub-board 301 is greater than the Young's modulus of the second sub-board. The high Young's modulus of the first sub-board 301 can improve reliability of the circuit board, and the low CTE of the first sub-board 301 can effectively reduce the CTE of the entire circuit board. It may be understood that, for the dielectric material of the first sub-board 301, a dielectric material with a small CTE and without considering an insertion loss is selected. For example, the dielectric material of the first sub-board 301 may be a bismaleimide triazine resin (BT resin), a high-rigidity epoxy resin, or the like. The dielectric material of the first sub-board 301 further includes a glass cloth with a low CTE, to ensure that the first sub-board 301 has a low CTE and a high Young's modulus. The glass cloth with a low CTE includes but is not limited to a high-strength glass (T-glass) glass cloth, a high-strength glass fiber (S-glass) glass cloth, and any other type of reinforcing material with a low CTE and a high Young's modulus. Copper foil on both sides of the first sub-board 301 may be reverse treated copper foil (RTF), RTF2, RTF3, high-frequency ultra-low profile copper foil (HVLP), ultra-thin separable copper foil with a thickness less than or equal to 5 µm in the target direction Z, or the like based on a minimum line width requirement. An interface treatment agent between the glass cloth and the copper foil is selected based on a resin system, for example, a silane coupling agent containing an amino or epoxy group. This is not specifically limited. For the first sub-board 301 shown in this example, a CTE of in the target plane XY is less than or equal to 10 ppm/°C, and a Young's modulus is greater than or equal to 10 Gipascals (Gpa). Optionally, the first sub-board 301 may be a fiber-reinforced composite material, and a glass transition temperature (Tg) of the first sub-board 301 is greater than or equal to 220°C. A quantity of layers of the first sub-board 301 is not limited in embodiments. For example, the first sub-board 301 is designed into a double-layer or multi-layer structure based on performance requirements such as power supplying, heat conduction, and shielding. An overall thickness of the first sub-board is greater than or equal to 400 µm. A thickness of the first sub-board 301 in the target direction Z shown in this embodiment is greater than a thickness of the second sub-board in the target direction Z, and the thickness of the first sub-board 301 in the target direction Z is greater than a thickness of the third sub-board in the target direction Z. It may be understood that the thickness of the first sub-board 301 in the target direction Z is the highest in the M sub-boards. In this case, when the first sub-board 301 has a low CTE in the target plane XY, the CTE of the entire circuit board is effectively reduced.

The second sub-board 302 is used as an example. The second sub-board 302 may be used as a signal layer (signal layer) with a high electrical requirement. The second sub-board 302 uses a dielectric material with a low Young's modulus and a low insertion loss. In other words, the Young's modulus of the second sub-board 302 is the lowest in the M sub-boards, and the Df of the second sub-board 302 is the lowest in the M sub-boards. For example, to implement a low insertion loss of the second sub-board 302, the Df of the second sub-board is less than or equal to 0.002, and to implement a low Young's modulus of the second sub-board 302, the Young's modulus of the second sub-board 302 is less than or equal to 5 GPa. In this example, the CTE of the second sub-board 302 in the target plane XY is greater than the CTE of the first sub-board 301 in the target plane XY. In this case, for the second sub-board 302, the CTE in the target plane XY is less than or equal to 35 ppm/°C, the Young's modulus is less than or equal to 3 GPa, and the Dk is less than or equal to 3.5 in this example. Optionally, the second sub-board 302 may be in a form of film material, sheet material, or resin-coated copper (resin-coated copper, RCC) foil. Optionally, if the second sub-board 302 is in an RCC form, copper foil of the second sub-board 302 is selected based on a line preparation process and a line width requirement. If the line preparation process is a modified semi-addition process (modified semi-addition process, mSAP) with a line width of less than or equal to 40 µm, carrier copper foil with a thickness of 1 µm to 5 µm may be used. If the line preparation process is a tenting (tenting) process is used, copper foil such as RTF, RTF2, RTF3, or HVLP may be used. The second sub-board 302 may not use a continuously-woven fiber cloth as a reinforcing material, to reduce an overall Young's modulus. The dielectric material of the second sub-board 302 may be a thermosetting resin or a thermoplastic resin. The thermosetting resin may be a modified epoxy resin (modified epoxy resin), a resin with low polarity, or polyphenylene oxide (polyphenylene oxide, PPO), and the polyphenylene oxide may also be referred to as polyphenylene ether (polyphenylene ether, PPE). The thermoplastic resin may be a liquid crystal polymer (liquid crystal polymer, LCP), polytetrafluoroethylene (polytetrafluoroethylene, PTFE), or polyimide (polyimide, PI).

As an information transmission rate of a communication device is increasingly high, and a capacity for transmitting information is increasingly large, a circuit board used in the communication device tends to develop at a high speed and high density. Correspondingly, a requirement for high-speed signal transmission performance of the circuit board is increasingly high, cables and/or via pitches are increasingly dense, and a size of an electronic component (like a chip) is increasingly large. As a result, a risk of reliability failures such as cracking of a solder joint, CAF, and HAST is increasingly high. To improve reliability of the communication device and reduce the via pitch, a dielectric material used by the circuit board needs to have performance of a low insertion loss, a small via pitch, and a low CTE in the target plane XY. However, in the circuit board shown in this embodiment, the second sub-board has performance of a low Df and a low Young's modulus, so that the second sub-board can implement a small via pitch. The pitch usually refers to a central distance between vias or pads on the circuit board. Specifically, because the second sub-board does not use the continuously woven fiber cloth as the reinforcing material, reliability capabilities such as CAF resistance and HAST resistance at a small pitch can be improved in an ultra-dense and small via pitch scenario, especially in a scenario in which a pitch is less than or equal to 200 µm. An impedance control requirement can be met at a low thickness. Due to the smaller thickness of the second sub-board, negative impact of the second sub-board on a CTE of the entire circuit board can be reduced, and a thickness of the entire circuit board can be reduced.

A third sub-board 304 is used as an example. The third sub-board 304 is used as an outermost layer of the PCB. Because operations such as surface mounted technology (surface mounted technology, SMT) mounting of a pad surface need to be considered, in this embodiment, an example in which a Young's modulus of the third sub-board 304 is the highest in the M sub-boards included in the circuit board is used. Specifically, the Young's modulus of the third sub-board 304 is greater than or equal to 7 GPa, and a Df is less than or equal to 0.004@10 GHz. A CTE of the third sub-board 304 in the target plane XY is less than or equal to 30 ppm/°C. To reduce a conductor loss of the third sub-board 304, low-roughness copper foil with a microscopic unevenness ten-point height (Rz) less than or equal to 3 µm is selected, and a thickness is determined based on a minimum line width requirement. In this embodiment, the thickness of the second sub-board 302 and the thickness of the third sub-board 304 are respectively less than or equal to 100 µm.

A Young's modulus of the circuit board may be obtained by using the following formula 4: ${E}_{PCB} = {E}_{1} {φ}_{1} + {E}_{2} {φ}_{2} + {E}_{…} {φ}_{…} + {E}_{n} {φ}_{n} ,$ where
E_{PCB} is a Young's modulus of the entire PCB, and 1 to n are codes of sub-boards on the PCB. The PCB includes a sub-board 1, a sub-board 2, ..., and a sub-board n. En is a Young's modulus of the sub-board n, and φn is a volume proportion of the sub-board n. In this embodiment, Young's moduli of the M circuit boards may be designed based on formula 4, to ensure that the Young's modulus of the second sub-board is the highest in the M sub-boards.

It may be understood that, by using the structure of the circuit board shown in this embodiment, the CTE and the Young's modulus of the entire circuit board may be adjusted based on a requirement for the CTE and the Young's modulus of the entire circuit board. Dielectric materials with different CTEs and Young's moduli may be used on different sub-boards, and thicknesses of different sub-boards are matched, to adjust the CTE and the Young's modulus of the entire circuit board. In this embodiment, the CTE of the entire circuit board is reduced by reducing the CTEs of the first sub-board and the third sub-board in the target plane XY. In this case, a requirement for the CTE of the second sub-board in the target plane XY may be reduced. Because the requirement for the CTE of the second sub-board in the target plane XY is reduced, the second sub-board may use a dielectric material with a small Df, to ensure that the circuit board provided in this embodiment can have both performance of a low CTE and a low insertion loss.

The following describes the structure of the circuit board with reference to a specific example.

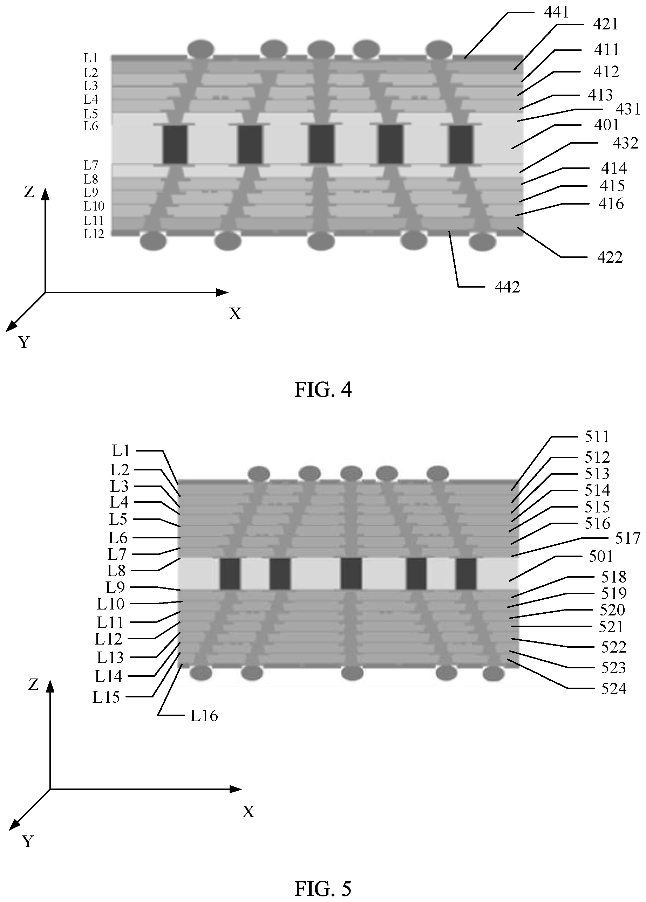

FIG. 4 is an example diagram of a structure of a circuit board according to a second embodiment of this application. As shown in FIG. 4, an example in which the circuit board is a high-density interconnector (high-density interconnector, HDI) circuit board is used.

FIG. 4 is an example diagram of a structure of the circuit board in a coordinate system XYZ. For descriptions of the coordinate system XYZ, refer to the descriptions corresponding to FIG. 1. Details are not described again. The circuit board shown in this embodiment specifically includes a first sub-board 401. For description of a structure of the first sub-board 401, refer to the descriptions of the first sub-board corresponding to FIG. 3. Details are not described again. The circuit board further includes a plurality of second sub-boards. In this embodiment, the circuit board includes six second sub-boards. To be specific, in a target direction Z, the circuit board sequentially includes a second sub-board 411, a second sub-board 412, a second sub-board 413, a second sub-board 414, a second sub-board 415, and a second sub-board 416 from top to bottom. A quantity of second sub-boards is not limited in embodiments. The circuit board may further include two third sub-boards. To be specific, in the target direction Z, the circuit board sequentially includes a third sub-board 421 and a third sub-board 422 from top to bottom. A quantity of third sub-boards is not limited in embodiments. In this embodiment, an example in which the plurality of second sub-boards are symmetrically distributed by using the first sub-board 401 as a center, and the plurality of third sub-boards are symmetrically distributed by using the first sub-board 401 as a center is used. For descriptions of a position relationship between the first sub-board, the second sub-board, and the third sub-board shown in this embodiment, refer to the embodiment corresponding to FIG. 3. Details are not described again. The M sub-boards shown in this embodiment may further include at least one fourth sub-board. In this embodiment, an example in which the circuit board includes two fourth sub-boards, namely, a fourth sub-board 431 and a fourth sub-board 432, is used. The plurality of fourth sub-boards are also symmetrically distributed by using the first sub-board 401 as a center. Specifically, the fourth sub-board 431 is located between the second sub-board 412 and the first sub-board 401, and the fourth sub-board 432 is located between the second sub-board 414 and the first sub-board 401.

A dielectric material of the fourth sub-board shown in this embodiment may be the same as that of the first sub-board, and/or the dielectric material of the fourth sub-board is the same as that of the third sub-board. In this embodiment, to suppress a CTE mismatch between the circuit board and an electronic component, a CTE of the circuit board needs to be reduced. A manner of reducing the CTE of the circuit board shown in this embodiment is that, in an XY plane, a CTE of the first sub-board 401 is less than a CTE of the second sub-board, a CTE of the third sub-board is less than the CTE of the second sub-board, and a CTE of the fourth sub-board is less than the CTE of the second sub-board. The CTEs of the first sub-board, the third sub-board, and the fourth sub-board are respectively less than the CTE of the second sub-board, so that a CTE of the entire circuit board is effectively reduced. For details, refer to the descriptions in the embodiment corresponding to FIG. 3. Details are not described again.

In this embodiment, to enable the circuit board to have both performance of a low CTE and a low insertion loss, a Df of the second sub-board is the smallest in the M sub-boards. To be specific, a Df of the first sub-board 401 is greater than the Df of the second sub-board, a Df of the third sub-board is greater than the Df of the second sub-board, and a DF of the fourth sub-board is greater than the DF of the second sub-board. It may be understood that, when the Df of the second sub-board is the smallest in the M circuit boards, an insertion loss of the circuit board is effectively reduced. In the circuit board shown in this embodiment, the third sub-board is located at an outermost layer. In this case, a Young's modulus of the third sub-board is the highest in the M sub-boards included in the circuit board, thereby effectively improving rigidity of the entire circuit board and reducing an indentation on a surface of the circuit board during mounting. In this embodiment, a Young's modulus of the second sub-board is the lowest in the M sub-boards. In this case, due to a low Young's modulus of the second sub-board, negative impact of a high CTE of the second sub-board on a CTE of the entire circuit board can be reduced as much as possible. The following specifically describes each sub-board of the circuit board.

The first sub-board 401 may be used as a power layer or a ground wire layer. For descriptions of the power layer and the ground layer, refer to the descriptions of the first sub-board corresponding to FIG. 3. Details are not described again. The first sub-board 401 in this embodiment has a high Young's modulus and a low CTE in the target plane XY, thereby improving stability of the structure of the circuit board, reducing a CTE of the entire circuit board, and improving warpage (warpage) of the entire circuit board. A dielectric material of the first sub-board 401 is a material whose CTE in the target plane XY is less than or equal to 10 ppm/°C, whose Young's modulus is greater than or equal to 10 GPa, and whose Df is not considered. For a specific description, refer to the descriptions of the dielectric material of the first sub-board 301 corresponding to FIG. 3. Details are not described again. Based on an actual board thickness and mechanical performance control requirements, a thickness of the first sub-board 401 is designed to be 100 µm to 1600 µm. In this embodiment, an example in which the thickness of the first sub-board 401 is greater than or equal to 200 µm is used.

The second sub-board 411 is used as an example. The second sub-board 411 may be in a form of film material, sheet material, or RCC. The second sub-board 411 does not use a continuously-woven fiber cloth as a reinforcing material, to reduce an overall Young's modulus. A dielectric material of the second sub-board 411 may be a thermosetting resin or a thermoplastic resin. For descriptions of the thermosetting resin or the thermoplastic resin, refer to the descriptions of the second sub-board corresponding to FIG. 3. Details are not described again. For the second sub-board 411, a Df is less than or equal to 0.002, and a Young's modulus is less than or equal to 5 GPa. A CTE of the second sub-board 411 in the target plane XY is less than or equal to 35 ppm/°C. In this embodiment, for the second sub-board 411, the Young's modulus is less than or equal to 3 GPa, the Dk is less than or equal to 3.5, and the thickness is less than or equal to 50 µm. If the second sub-board 411 is prepared in an RCC form, the thickness and copper foil are selected based on a line preparation process and a line width requirement. If the line preparation process is an mSAP process (a line width is 20 µm to 50 µm), carrier copper foil of 1 µm to 3 µm may be used. If the line preparation process is a tenting process (a line width is greater than or equal to 40 µm), copper foil such as RTF, RTF2, RTF3, and HVLP may be used. For descriptions of any second sub-board included in the circuit board, refer to the descriptions of the second sub-board 411. Details are not described again.

The third sub-board 421 is used as an example. The third sub-board 421 may have both performance of a low CTE and a low insertion loss. A dielectric material of the third sub-board 421 may be a material with performance of a small CTE and a low insertion loss. Specifically, a CTE of the third sub-board 421 in the target plane XY is less than a CTE of the second sub-board in the target plane XY. A Df of the third sub-board 421 is greater than a Df of the second sub-board 411. For example, a dielectric material of the third sub-board 421 may be modified high-rigidity epoxy+BT resin. A low-polarity CH resin is further partially introduced into the dielectric material of the third sub-board 421, and overall performance is controlled through pre-polymerization. Optionally, the dielectric material of the third sub-board 421 may be used together with a glass cloth having a low Dk to obtain good electrical performance. For example, the glass cloth may be an NE-glass (NE-glass) fiber cloth, an NER-glass (NER-glass) fiber cloth, a low-loss glass (L-glass) fiber cloth, an L2-glass cloth, or another glass cloth having a low Dk. Optionally, to reduce a conductor loss, low-roughness copper foil with Rz less than or equal to 3 µm is selected for the third sub-board 421, and a thickness is determined based on a minimum line width requirement. Because the third sub-board 421 uses a glass fiber cloth reinforced dielectric material, no high-density via pitch is set in this layer. In this case, for the third sub-board 421, the CTE in the target plane XY is less than or equal to 17 ppm/°C, the Young's modulus is greater than or equal to 7 GPa, the Df is less than or equal to 0.004@10 GHz, and the thickness is less than or equal to 100 µm. For descriptions of the fourth sub-board, refer to the descriptions of the first sub-board or the third sub-board 421. Details are not described again.

Refer to Table 1. The following describes a thickness of copper foil clad by each sub-board of the circuit board, a thickness of each sub-board, and a copper foil cladding process.

**Table 1**

| Layer (layer) level | Stacked | Thickness/µm | Process type |
|---|---|---|---|
| | Solder masker (solder masker) 441 | 20 | |
| Layer 1 | Copper (Copper) foil | 25 | mSAP |
| | Third sub-board 421 | 30 to 40 | |
| Layer 2 | Copper | 12 to 15 | mSAP |
| | Second sub-board 411 | 30 to 40 | |
| Layer 3 | Copper | 12 to 15 | mSAP |
| | Second sub-board 412 | 30 to 40 | |
| Layer 4 | Copper | 12 to 15 | mSAP |
| | Second sub-board 413 | 30 to 40 | |
| Layer 5 | Copper | 12 to 15 | mSAP |
| | Fourth sub-board 431 | 30 to 40 | |
| Layer 6 | Copper | 12 to 15 | Tenting |
| | First sub-board 401 | 400 to 1200 | |
| Layer 7 | Copper | 12 to 15 | Tenting |
| | Fourth sub-board 432 | 30 to 40 | |
| Layer 8 | Copper | 12 to 15 | mSAP |
| | Second sub-board 414 | 30 to 40 | |
| Layer 9 | Copper | 12 to 15 | mSAP |
| | Second sub-board 415 | 30 to 40 | |
| Layer 10 | Copper | 12 to 15 | mSAP |
| | Second sub-board 416 | 30 to 40 | |
| Layer 11 | Copper | 12 to 15 | mSAP |
| | Third sub-board 422 | 30 to 40 | |
| Layer 12 | Copper | 25 | mSAP |
| | Solder masker 442 | 20 | |

It may be understood that the layer L1 is copper foil covering a surface of the third sub-board 421, the layer L2 is copper foil covering a surface of the second sub-board 411, and so on. The layer 12 is copper foil covering a surface of the third sub-board 422.

Based on the requirement for the CTE and the Young's modulus of the entire PCB, dielectric materials with performance of different CTE and Young's moduli may be used on different sub-boards, so that the CTE and Young's modulus of the PCB can be designed to be adjustable. For details, refer to the following Table 2.

**Table 2**

| | First sub-board | | Fourth sub-board and third sub-board | | Second sub-board | | Mechanical performance of the PCB | | Performance of the second sub-board | |
|---|---|---|---|---|---|---|---|---|---|---|
| | CTE/ ppm/ °C in the target plane XY | Young's modulus/ GPa | CTE/ ppm/ °C in the target plane XY | Young's modulus/ GPa | CTE/ ppm/ °C in the target plane XY | Young's modulus/ GPa | CTE/ppm/°C in the target plane XY | Young's modulus/ GPa | Dk | Df |
| Example 1 | 8 | 30 | 15 | 20 | 35 | 2 | 25.4 | 11.9 | 3.0 | 0.0012 |
| Example 2 | 8 | 30 | 15 | 20 | 30 | 2 | 25.4 | 11.8 | 3.0 | 0.0012 |
| Example 3 | 8 | 30 | 15 | 20 | 25 | 2 | 25.4 | 11.7 | 3.0 | 0.0012 |
| Example 4 | 8 | 30 | 15 | 20 | 30 | 5 | 26.1 | 12.3 | 3.0 | 0.0012 |
| Example 5 | 8 | 30 | 15 | 20 | 30 | 3 | 25.6 | 12.0 | 3.0 | 0.0012 |
| Example 6 | 8 | 30 | 15 | 20 | 30 | 1 | 25.2 | 11.7 | 3.0 | 0.0012 |
| Example 7 | 10 | 30 | 15 | 20 | 30 | 2 | 25.4 | 13.0 | 3.0 | 0.0012 |
| Example 8 | 8 | 30 | 13 | 20 | 30 | 2 | 25.4 | 11.5 | 3.0 | 0.0012 |

The structures of the circuit boards shown in Example 1 to Example 8 in Table 2 are all implemented by using the embodiment shown in FIG. 4. In other words, the CTE of the first sub-board in the XY plane is the lowest in the plurality of sub-boards included in the circuit board. The Young's modulus of the second sub-board is the lowest in the plurality of sub-boards included in the circuit board. In the examples described in Table 2, for example, the dielectric material of the third sub-board is the same as the dielectric material of the fourth sub-board. CTEs in the target plane XY and Young's moduli of the third sub-board and the fourth sub-board are between those of the first sub-board and the second sub-board. Specifically, in Example 1, for the first sub-board, the dielectric material is a glass fiber cloth-reinforced dielectric material, the CTE in the target plane XY is 8 ppm/°C, the Young's modulus is 30 GPa, the Df is greater than or equal to 0.008/10 GHz, and the thickness is 410 µm. The third sub-board and the fourth sub-board use a same dielectric material. For both the third sub-board and the fourth sub-board, the glass fiber cloth-reinforced dielectric material is used, the CTE in the target plane XY is 15 ppm/°C, the Young's modulus is 20 GPa, the Df is 0.004/10 GHz, and the thickness is 40 µm. For the second sub-board, a non-fiber-reinforced membrane material is used, the CTE in the target plane XY is 35 ppm/°C, the Young's modulus is 2 GPa, the Df is 0.0012/10 GHz, the thickness is 30 µm, and Dk is 3.0. In this case, in Example 1, for the entire PCB, the CTE in the target plane XY is 25.4 ppm/°C, and the Young's modulus is 11.9 GPa. The Dk of the PCB is 3.0, and the Df is 0.012. Example 2 to Example 8 are deduced by analogy. Details are not described again.

For performance of each sub-board of the circuit board shown in FIG. 2, refer to Table 3.

**Table 3**

| | First sub-board | | | Second sub-board | | Mechanical performance of the PCB | | Performance of the second sub-board | |
|---|---|---|---|---|---|---|---|---|---|
| | CTE/ppm/ °C in the target plane XY | Young's modulus/ GPa | CTE/ppm/ °C in the target plane XY | | Young's modulus/ GPa | CTE/ppm/ °C in the target plane XY | Young's modulus/ GPa | Dk | Df |
| Comparative example 1 | 8 | 30 | 15 | | 20 | 28.7 | 12.1 | 3.6 | 0.0038 |
| Comparative example 2 | 10 | 30 | 15 | | 20 | 28.7 | 13.1 | 3.6 | 0.0038 |
| Comparative example 3 | 8 | 30 | 13 | | 20 | 28.7 | 11.5 | 3.6 | 0.0038 |

For a specific description of the circuit board corresponding to Table 3, refer to FIG. 2. Details are not described again. In Comparative example 1, for the dielectric material of the first sub-board, the CTE of in the target plane XY is 8 ppm/°C, the Young's modulus is 30 GPa, and the thickness is 410 µm. For the second sub-board, the CTE in the target plane XY is 15 ppm/°C, the Young's modulus is 20 GPa, and the thickness is 40 µm. Because in an existing circuit board, the dielectric material of the second sub-board cannot have both performance of a low CTE and a low insertion loss, the Df of the second sub-board is large, and is 0.0038@10 GHz. In other words, in the circuit board shown in FIG. 2, the CTE of the first sub-board in the target plane XY is the lowest in the sub-boards included in the circuit board, and the Young's modulus of the first sub-board is the highest in the sub-boards included in the circuit board. In this case, the CTE of the corresponding entire circuit board in the target plane XY is 28.7, and the Young's modulus is 12.1.

It can be learned with reference to Table 2 and Table 3 that, by using structure of the circuit board shown in FIG. 4, compared with the structure of the circuit board corresponding to FIG. 2, the CTE of the circuit board in the target plane XY is lower. In addition, the circuit board shown in FIG. 4 can implement that the second sub-board has both performance of an ultra-low Df and a low Dk, so that high-speed signal layer transmission can be implemented, and an insertion loss is effectively reduced.

According to the structure of the circuit board shown in this embodiment, the circuit board includes a plurality of dielectric materials with different performance, and different performance such as a low CTE, a high Young's modulus, and a low insertion loss in the target plane XY is distributed to different sub-boards included in the circuit board. For example, the CTE of the first sub-board in the target plane XY is less than the CTE of the second sub-board in the target plane XY. The Young's modulus of the second sub-board is the lowest in the M sub-boards. The Df of the second sub-board is the lowest in the M sub-boards. It may be understood that a low CTE and a low Df in the target plane XY are respectively distributed to the first sub-board and the second sub-board. Because the CTE of the first sub-board in the target plane XY is low, a CTE of the entire circuit board in the target plane XY is effectively reduced. Because the Df of the second sub-board is low, the insertion loss of the circuit board is effectively reduced. In addition, the Young's modulus of the second sub-board is the lowest in the M sub-boards, thereby effectively suppressing a high CTE of the second sub-board and reducing negative impact on the CTE of the entire circuit board. When the CTE of the circuit board in the target plane XY is reduced, a CTE mismatch between the circuit board and the electronic component is effectively suppressed. The Young's modulus of the first sub-board and the Young's modulus of the third sub-board are both higher than the Young's modulus of the second sub-board, thereby effectively improving reliability of a structure of the entire circuit board.

Because the first sub-board shown in this embodiment has a low CTE in the target plane XY, and the first sub-board does not need to have a low insertion loss (namely, a low Df), the dielectric material of the first sub-board does not need to have both performance of reducing the CTE and performance of reducing the insertion loss, thereby effectively reducing costs and preparation difficulty of the first sub-board. The circuit board shown in this embodiment can achieve the following objective: namely, a scenario in which, for the entire circuit board, the CTE in the target plane XY is less than or equal to 15 ppm/°C, and the Df is less than or equal to 0.001, to ensure that the entire circuit board has a low CTE and a low insertion loss in the target plane XY, and ensure reliability of the structure of the circuit board.

FIG. 4 shows an example in which the circuit board includes 12 layers of copper foil. It should be noted that a quantity of copper foil included in the circuit board is not limited in embodiments. For example, the circuit board includes 16 layers of copper foil. First, with reference to FIG. 5, a structure of an existing circuit board including 16 layers of copper foil is described. FIG. 5 is an example diagram of another structure of the existing circuit board.

The circuit board includes a first sub-board 501 covered with copper foil on both sides. For descriptions of the first sub-board 501, refer to the descriptions corresponding to FIG. 2. Details are not described again. The circuit board further includes 14 second sub-boards that are sequentially stacked from top to bottom in a direction Z, namely, a second sub-board 511, a second sub-board 512, a second sub-board 513, a second sub-board 514, a second sub-board 515, a second sub-board 516, a second sub-board 517, a second sub-board 518, a second sub-board 519, a second sub-board 520, a second sub-board 521, a second sub-board 522, a second sub-board 523, and a second sub-board 524. The 14 second sub-boards are symmetrically distributed by using the first sub-board 501 as a center. For descriptions of each second sub-board, refer to the descriptions of the second sub-board corresponding to FIG. 2. Details are not described again. The circuit board corresponding to FIG. 5 includes 15 layers of copper foil, namely, L1, L2, ..., and L16. L1 is copper foil covering a surface of the second sub-board 511, ..., and L16 is copper foil covering a surface of the second sub-board 524. For performance of the circuit board corresponding to FIG. 5, refer to Table 4.

**Table 4**

| Structure | First sub-board | | Second sub-board | | Overall PCB result | |
|---|---|---|---|---|---|---|
| | Position | Thickness/µm | Position | Thickness/µm | Young's modulus/GPa | CTE/ppm/°C in the target plane XY |
| Circuit board corresponding to FIG. 5 | L8/L9 | 400 µm | All | 70 µm | 30.2 | 13.2 |

The structure of the existing circuit board shown in FIG. 5 is used. Both sides of the first sub-board 501 are respectively covered with copper foil L8 and copper foil L9. A thickness of the first sub-board 501 in the target direction Z is 400 µm. A thickness of each of the 14 second sub-boards in the target direction Z is 70 µm. In the circuit board corresponding to FIG. 5, a Young's modulus of the entire circuit board is 30.2 GPa, and a CTE in the target plane XY is 13.2 ppm/°C.

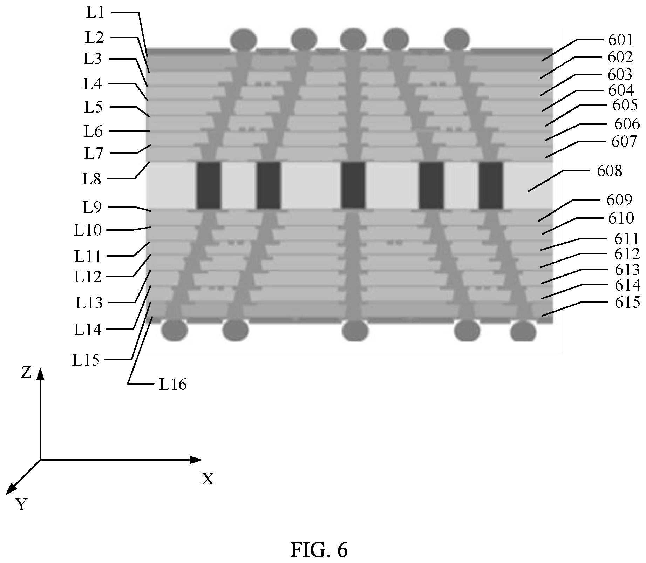

FIG. 6 is an example diagram of a structure of a circuit board according to a third embodiment of this application. The circuit board shown in FIG. 6 also includes 15 layers of copper foil. This embodiment shows an example diagram of a structure of the circuit board in a coordinate system XYZ. For descriptions of the coordinate system XYZ, refer to the descriptions corresponding to FIG. 3. Details are not described again. The circuit board shown in this embodiment includes a sub-board 601, a sub-board 602, and a sub-board 603 to a sub-board 615 that are sequentially stacked in a target direction Z. For performance of the circuit board corresponding to FIG. 6, refer to Table 5.

**Table 5**

| Circuit board correspon ding to FIG. 6 | First sub-board | | Third sub-board | | Second sub-board | | | | Overall PCB result | |
|---|---|---|---|---|---|---|---|---|---|---|
| | Position | Thick ness/ µm | Position | Thickness/ µm | Position | Thickness/ µm | CTE/ ppm/ °C in the target plane | Young's modulus/ GPa | Young's modulus/ GPa | CTE/ ppm/ °C in the target plane XY |
| Example 1 | Sub-board 608 | 400 µm | Sub-boards 601, 603, 604, 605, 606, 609, 610, 611, 612, and 613 | 70 µm | Sub-boards 602 and 614 | 50 µm | 30 ppm/ °C | 3 GPa | 28.4 GPa | 13.4 |
| Example 2 | Sub-board 608 | 400 µm | Sub-boards 601,604, 605, 606, 609, 610, 611, and 612 | 70 µm | Sub-boards 602, 603, 614, and 613 | 50 µm | 30 ppm/ °C | 3 GPa | 26.7 GPa | 13.6 |
| Example 3 | Sub-board 608 | 400 µm | Sub-boards 601, 604, 606, 607, 609, 610, 612, and 615 | 70 µm | Sub-boards 602, 603, 605, 611, 613, and 614 | 50 µm | 30 ppm/ °C | 3 GPa | 24.9 GPa | 13.8 |
| Example 4 | Sub-board 608 | 400 µm | Sub-boards 601, 604, 606, 607, 609, 610, 612, and 615 | 70 µm | Sub-boards 602, 603, 605, 611, 613, and 614 | 50 µm | 30 ppm/ °C | 3 GPa | 23.1 GPa | 14.1 |
| Example 5 | Sub-board 608 | 500 µm | Sub-boards 601, 604, 606, 607, 609, 610, 612, and 615 | 70 µm | Sub-boards 602, 603, 605, 611, 613, and 614 | 50 µm | 30 ppm/ °C | 3 GPa | 25.1 GPa | 13.8 |

In Example 1 of the circuit board corresponding to FIG. 6, the sub-board 608 is a first sub-board, the sub-boards 601, 603, 604, 605, 606, 609, 610, 611, 612, and 613 are third sub-boards, and the sub-boards 602 and 614 are second sub-boards. For descriptions of the first sub-board, the second sub-board, and the third sub-board, refer to the descriptions corresponding to FIG. 3. Details are not described again. In the circuit board corresponding to Example 1, performance of the first sub-board is that for the first sub-board 608, a CTE in the target plane XY is 10 ppm/°C, a Young's modulus is 20 GPa, and a thickness in the target direction Z is 400 µm. For each third sub-board, a CTE in the target plane XY is 13 ppm/°C, a Young's modulus is 15 GPa, and a thickness in the target direction Z is 70 µm. The second sub-board may be in an RCC form. For each second sub-board, a CTE in the target plane XY is 30 ppm/°C, a Young's modulus is 3 GPa, and a thickness in the target direction Z is 50 µm. As shown in Table 5, it can be learned that the CTE of the first sub-board in the XY plane is the lowest in the sub-boards included in the circuit board. The Young's modulus of the second sub-board is the lowest in the sub-boards included in the circuit board. For a specific description, refer to the descriptions corresponding to FIG. 3. Details are not described again. In this case, for the entire circuit board shown in Example 1, a CTE in the target plane XY is 13.4, and the Young's modulus is 28.4 GPa.

In Example 2, the sub-board 608 is a first sub-board, the sub-boards 601, 604, 605, 606, 609, 610, 611, and 612 are third sub-boards, and the sub-boards 602, 603, 614, and 613 are second sub-boards. For descriptions of the first sub-board, the second sub-board, and the third sub-board, refer to the descriptions corresponding to FIG. 3. Details are not described again. For descriptions of performance of the first sub-board, the second sub-board, and the third sub-board, refer to the descriptions shown in Example 1. Details are not described again. When the circuit board shown in Example 2 is used, for the entire circuit board, the CTE in the target plane XY is 13.6, and the Young's modulus is 26.7 GPa.

In Example 3, the sub-board 608 is a first sub-board, the sub-boards 601, 604, 606, 607, 609, 610, 612, and 615 are third sub-boards, and the sub-boards 602, 603, 605, 611, 613, and 614 are second sub-boards. For descriptions of the first sub-board, the second sub-board, and the third sub-board, refer to the descriptions corresponding to FIG. 3. Details are not described again. For descriptions of performance of the first sub-board, the second sub-board, and the third sub-board, refer to the descriptions shown in Example 1. Details are not described again. When the circuit board shown in Example 3 is used, for the entire circuit board, the CTE in the target plane XY is 13.8, and the Young's modulus is 24.9 GPa.

In Example 4, the sub-board 608 is a first sub-board, the sub-boards 601, 604, 606, 607, 609, 610, 612, and 615 are third sub-boards, and the sub-boards 602, 603, 605, 611, 613, and 614 are second sub-boards. For descriptions of the first sub-board, the second sub-board, and the third sub-board, refer to the descriptions corresponding to FIG. 3. Details are not described again. For descriptions of performance of the first sub-board, the second sub-board, and the third sub-board, refer to the descriptions shown in Example 1. Details are not described again. When the circuit board shown in Example 4 is used, for the entire circuit board, the CTE in the target plane XY is 14.1, and the Young's modulus is 23.1 GPa.

It can be learned from comparison between Example 1 to Example 4 shown in Table 4 and Table 5 that, by adopting the structure of the circuit board corresponding to FIG. 6, compared with a result obtained by using the existing circuit board corresponding to FIG. 5, a CTE of the structure of the circuit board shown in FIG. 6 may be close to or equivalent to that of the existing circuit board. However, the structure of the circuit board shown in FIG. 6 can effectively reduce an insertion loss.

In Example 5 shown in Table 5, the sub-board 608 is a first sub-board, the sub-boards 601, 604, 606, 607, 609, 610, 612, and 615 are third sub-boards, and the sub-boards 602, 603, 605, 611, 613, and 614 are second sub-boards. For descriptions of the first sub-board, the second sub-board, and the third sub-board, refer to the descriptions corresponding to FIG. 3. Details are not described again. A difference between Example 4 and Example 5 lies in that the thickness of the first sub-board shown in Example 5 in the target direction Z is 500 µm. For descriptions of performance of the first sub-board, the second sub-board, and the third sub-board, refer to Example 1. Details are not described again. When the circuit board shown in Example 4 is used, for the entire circuit board, the CTE in the target plane XY is 13.8, and the Young's modulus is 25.1 GPa. It can be learned from comparison between Example 4 and Example 5 that, when the thickness of the first sub-board in the target direction Z is increased, the CTE in the target plane XY is reduced. For example, in the target direction Z, when the thickness of the first sub-board shown in Example 5 is greater than the thickness of the first sub-board shown in Example 4, the CTE of the circuit board shown in Example 5 in the target plane XY is less than the CTE of the circuit board shown in Example 4 in the target plane XY.

As shown in Table 5, an example in which quantities of layers of second sub-boards included in the circuit board are different in different examples is used. For example, as shown in table 5, two layers of second sub-boards are included in Example 1, four layers of second sub-boards are included in Example 2, and six layers of second sub-boards are included in Example 3. In a performance list shown in Table 6, the circuit board corresponding to FIG. 6 includes a fixed quantity of first sub-boards, second sub-boards, and third sub-boards. A different example is that the second sub-boards have different Young's moduli.

**Table 6**

| Circuit board correspo nding to FIG. 6 | First sub-board | | Third sub-board | | Second sub-board | | | | Overall PCB result | |
|---|---|---|---|---|---|---|---|---|---|---|
| | Position | Thick ness/ µm | Position | Thickne ss/µm | Position | Thickness/ µm | CTE/ ppm/ °C in the target plane | Young's modulus/ GPa | Young's modulus/ GPa | CTE/ ppm/ °C in the target plane XY |
| Example 1 | Sub-board 608 | 400 µm | Sub-boards 601, 604, 606, 607, 609, 610, 612, and 615 | 70 µm | Sub-boards 602, 603, 605, 611, 613, and 614 | 50 µm | 30 ppm/ °C | 1 GPa | 22.3 | 13.6 |
| Example 2 | Sub-board 608 | 400 µm | Sub-boards 601, 604, 606, 607, 609, 610, 612, and 615 | 70 µm | Sub-boards 602, 603, 605, 611, 613, and 614 | 50 µm | 30 ppm/ °C | 2 GPa | 22.7 | 13.9 |

In Example 1 and Example 2 shown in Table 6, the first sub-board is the sub-board 608, and the second sub-boards are sub-board 602, 603, 605, 611, 613, and 614. The third sub-boards are the sub-board 601, 604, 606, 607, 609, 610, 612, and 615. For descriptions of performance of each sub-board, refer to the descriptions corresponding to Table 5. Details are not described again. A difference between Example 1 and Example 2 included in Table 6 lies in that a Young's modulus of the second sub-board shown in Example 1 is 1 GPa, and a Young's modulus of the second sub-board shown in Example 2 is 2 GPa. It can be learned from comparison between Example 1 and Example 2 included in Table 6 that, when the Young's modulus of the second sub-board in Example 2 is greater than the Young's modulus of the first sub-board in Example 1, a Young's modulus of the entire circuit board in Example 2 is greater than a Young's modulus of the entire circuit board in Example 1. The CTE of the circuit board shown in Example 2 in the target plane XY is greater than the CTE of the circuit board shown in Example 1 in the target plane XY.

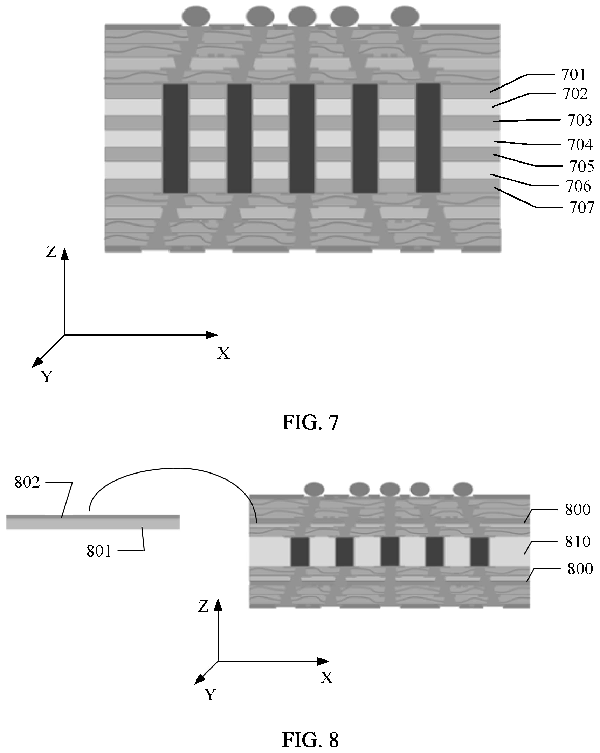

FIG. 7 is an example diagram of a structure of a circuit board according to a fourth embodiment of this application. FIG. 7 is an example diagram of the structure of the circuit board in a coordinate system XYZ. For descriptions of the coordinate system XYZ, refer to the descriptions corresponding to FIG. 3. Details are not described again. The circuit board shown in FIG. 7 includes a plurality of first sub-boards in a target direction Z. For example, in this embodiment, the circuit board includes seven layers of first sub-boards, namely, a first sub-board 701, a first sub-board 702, a first sub-board 703, a first sub-board 704, a first sub-board 705, a first sub-board 706, and a first sub-board 707. In this embodiment, a quantity of layers of the first sub-boards included in the circuit board may be designed based on performance requirements such as power supplying, heat conduction, and shielding. The first sub-board 702, the first sub-board 704, and the first sub-board 706 are CCLs, and the first sub-board 701, the first sub-board 703, the first sub-board 705, and the first sub-board 707 are prepregs (prepregs, PPs). It may be understood that, in the plurality of first sub-boards, in two first sub-boards adjacent to each other in the target direction Z, one first sub-board is a CCL, and the other first sub-board is a PP. Optionally, an overall thickness of the plurality of first sub-boards in the target direction Z is greater than or equal to 400 µm. The circuit board further includes a plurality of layers of second sub-boards and third sub-boards. For descriptions of the second sub-board and the third sub-board, refer to the foregoing embodiment. Details are not described again.

The second sub-board shown in this embodiment may be in a form of film material, sheet material, RCC, or the like. For example, if the second sub-board is in a form of film material or RCC, the second sub-board specifically includes a first dielectric layer. A CTE of the first dielectric layer in the target plane XY is greater than bother the CTE of the first sub-board and the CTE of the third sub-board, and a Df of the first dielectric layer is less than both the Df of the first sub-board and the Df of the third sub-board. For descriptions of the CTE, the Df, and a Young's modulus of the first dielectric layer, refer to the descriptions of the CTE, the Df, and the Young's modulus of the second sub-board in the foregoing embodiment. Details are not described again. For example, in this example, for the first dielectric layer, the Df is less than or equal to 0.002, the Young's modulus is less than or equal to 5 GPa, the CTE in the target plane XY is less than or equal to 35 ppm/°C, and the thickness is less than or equal to 50 µm. The first dielectric layer has a first surface and a second surface that are opposite to each other, and the first surface and the second surface of the first dielectric layer are arranged in the target direction Z. In other words, in the target direction Z, the first surface is an upper surface of the first dielectric layer, and the second surface is a lower surface of the first dielectric layer. At least one of the first surface or the second surface covers at least one second dielectric layer. For example, the first surface covers one layer, two layers, or any quantity of layers of second dielectric layers, and/or the second surface covers one layer, two layers, or any quantity of layers of second dielectric layers. The second dielectric layer is configured to increase a bonding force between the second sub-board and the copper foil, or improve adhesive filling performance of the second sub-board, or improve indentation resistance of a surface layer of the second sub-board, or the like. A thickness of the second dielectric layer in the target direction Z shown in this example is less than or equal to 10 µm. A dielectric material of the first dielectric layer shown in this example is different from a dielectric material of the second dielectric layer.

The first dielectric layer and the second dielectric layer shown in this example satisfy at least one of the following conditions:

A Df of the second dielectric layer is less than a Df of the first dielectric layer, a Young's modulus of the second dielectric layer is greater than a Young's modulus of the first dielectric layer, and a CTE of the second dielectric layer is less than a CTE of the first dielectric layer.

For example, FIG. 8 is an example diagram of a structure of a circuit board according to a fifth embodiment of this application. For example, the second sub-board is made of a film material. Specifically, the second sub-board includes a first dielectric layer 801 and a second dielectric layer 802 covering a first surface of the first dielectric layer 801. The circuit board may specifically include two second sub-boards 800, and the two second sub-boards 800 are symmetrically distributed by using the first sub-board 810 as a center. For specific descriptions of the first sub-board 810 and the second sub-board 800 included in the circuit board, refer to the foregoing embodiment. Details are not described again. It may be understood that, because the second sub-board shown in this example includes the first dielectric layer and the second dielectric layer, the second sub-board includes a plurality of layers of dielectric materials. A quantity of dielectric material layers included in the second sub-board is not limited in embodiments. In this embodiment, an example in which the circuit board includes two second sub-boards is used. In another example, the circuit board may include any integer number of second sub-boards. A quantity of second sub-boards included in the circuit board is not limited. The first sub-board, the third sub-board, and the fourth sub-board provided in this embodiment each may also include a first dielectric layer and a second dielectric layer. For descriptions of the first dielectric layer and the second dielectric layer, refer to the descriptions of the first dielectric layer and the second dielectric layer included in the first sub-board. Details are not described again.

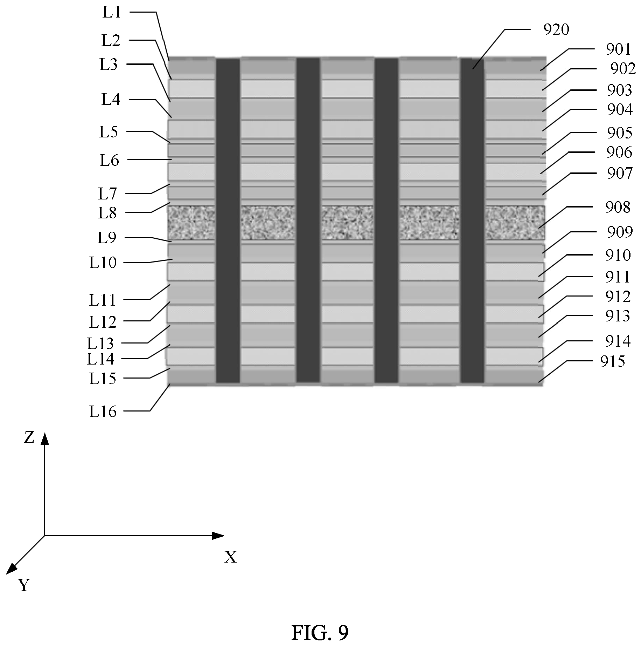

In the foregoing embodiment, the circuit board is an HDI. In this case, an electrical interconnection between different sub-boards of the circuit board is implemented by using a micro buried blind via. Specifically, the HDI uses laser to directly drill a hole on each sub-board to form a conductive through hole (Through hole), a buried via (Buried via), and a blind via (Blind via) used to implement the electrical interconnection between different sub-boards. However, in the embodiment shown in FIG. 9, the electrical interconnection between sub-boards included in the circuit board is implemented by using a through hole. FIG. 9 is an example diagram of a structure of a circuit board according to a sixth embodiment of this application. FIG. 9 is described by using an example in which the circuit board includes 15 layers of sub-boards. To be specific, in this embodiment, the sub-board 901, the sub-board 902 to the sub-board 915 are sequentially arranged from top to bottom in the circuit board in a target direction Z. The circuit board includes 16 layers of copper foil, and the layer L1, and the layer L2 to the layer L16 are sequentially arranged from top to bottom in the target direction Z. The layer L1 is copper foil covering a surface of the sub-board 901, the layer L2 is copper foil covering a surface of the sub-board 902, and so on. The layer 116 is copper foil covering a surface of the sub-board 915. It should be noted that, neither a quantity of sub-boards included in the circuit board nor a quantity of copper foils is limited in this embodiment.

Specifically, the first sub-board included in the circuit board is the sub-board 908, the sub-board 901, and the sub-board 915 are respectively third sub-boards, and the sub-board 902, the sub-board 903, the sub-board 904, the sub-board 905, the sub-board 906, the sub-board 907, the sub-board 909, the sub-board 910, the sub-board 911, the sub-board 912, the sub-board 913, and the sub-board 914 are respectively second sub-boards. For descriptions of the first sub-board, the second sub-board, and the third sub-board, refer to the foregoing embodiment. Details are not described again. The sub-board 901 and the sub-board 915 included in the circuit board shown in this embodiment are located on two sides of a surface. The circuit board includes a plurality of through holes 920, and the through holes 920 pass through each sub-board included in the circuit board from one side of the sub-board 901. In this way, the through holes 920 pass through the entire circuit board in the target direction Z, to pass through the sub-board 915. The through hole 920 can implement an electrical connection between sub-boards included in the circuit board, and provide an electrical connection and mechanical support. A quantity of through holes included in the circuit board is not limited in this embodiment. It may be understood that a CTE of the second sub-board in the target plane XY is the highest in the sub-boards included in the circuit board. A Young's modulus of the second sub-board is the lowest in the sub-boards included in the circuit board. A Df of the second sub-board is the lowest in the sub-boards included in the circuit board.

For performance of each sub-board included in the circuit board shown in this embodiment, refer to Table 7.

**Table 7**

| Layer level | Stacked | Thickness/µm |
|---|---|---|
| | Solder masker | 35 |
| Layer 1 | Copper | 70 |
| | Sub-board 901 | Greater than or equal to 50 |
| Layer 2 | Copper | 18 to 35 |
| | Sub-board 902 | 30 to 50 |
| Layer 3 | Copper | 18 to 35 |
| | Sub-board 903 | 30 to 50 |
| Layer 4 | Copper | 18 to 35 |
| | Sub-board 904 | 30 to 50 |
| Layer 5 | Copper | 18 to 35 |
| | Sub-board 905 | 30 to 50 |
| Layer 6 | Copper | 18 to 35 |
| | Sub-board 906 | 30 to 50 |
| Layer 7 | Copper | 18 to 35 |
| | Sub-board 907 | 30 to 50 |
| Layer 8 | Copper | 18 to 70 |
| | Sub-board 908 | 200 to 1200 |
| Layer 9 | Copper | 18 to 70 |
| | Sub-board 909 | 30 to 50 |
| Layer 10 | Copper | 18 to 35 |
| | Sub-board 910 | 30 to 40 |
| Layer 11 | Copper | 18 to 35 |
| | Sub-board 911 | 30 to 40 |
| Layer 12 | Copper | 18 to 35 |
| | Sub-board 912 | 30 to 50 |
| Layer 13 | Copper | 18 to 35 |
| | Sub-board 913 | 30 to 50 |
| Layer 14 | Copper | 18 to 35 |
| | Sub-board 914 | 30 to 50 |
| Layer 15 | Copper | 18 to 35 |
| | Sub-board 915 | Greater than or equal to 50 |
| Layer 16 | Copper | 70 |
| | Solder masker | 35 |

The sub-board 908 used as the first sub-board may be used as a power layer or a ground wire layer. A high Young's modulus of the first sub-board improves reliability of the circuit board. A low CTE of the first sub-board effectively reduces a CTE of the entire circuit board. It may be understood that a material with a small CTE and no loss is selected as a dielectric material of the first sub-board. For specific descriptions of the dielectric material, refer to the descriptions of the dielectric material used to prepare the first sub-board in the foregoing embodiments. Details are not described again. In this embodiment, for the first sub-board, a CTE in the target plane XY is less than or equal to 10 ppm/°C and a Young's modulus is greater than or equal to 10 GPa, and a thickness of the first sub-board ranges from 100 µm to 1600 µm. For example, in this embodiment, the thickness of the first sub-board is greater than or equal to 200 µm.

The sub-board 901 and the sub-board 915 are used as the third sub-boards. The third sub-boards are outermost layers of the circuit board. The third sub-board shown in this embodiment can meet requirements of a low CTE and a low loss in the target plane XY. In other words, a dielectric material of the third sub-board may be a material with performance of a small CTE and a low insertion loss. For descriptions of the dielectric material of the third sub-board, refer to the foregoing embodiments. Details are not described again. A thickness of low-roughness copper foil Rz that covers the third sub-board is less than or equal to 3 µm, and is determined based on a minimum line width requirement. For the third sub-board, a CTE of in the target plane XY is less than or equal to 17 ppm/°C, a Young's modulus is greater than or equal to 7 GPa, a Df is less than or equal to 0.004@10 GHz, and a thickness is less than or equal to 100 µm.

The sub-board 902, the sub-board 903, the sub-board 904, the sub-board 905, the sub-board 906, the sub-board 907, the sub-board 909, the sub-board 910, the sub-board 911, the sub-board 912, the sub-board 913, and the sub-board 914 are used as the second sub-boards. A plurality of second sub-boards included in the circuit board may be in two different structural forms. The second sub-boards in the two structural forms may be spaced apart. For example, the sub-board 902, the sub-board 904, the sub-board 906, the sub-board 910, the sub-board 912, and the sub-board 914 have the first structural form. The sub-board 903, the sub-board 905, the sub-board 907, the sub-board 909, the sub-board 911, and the sub-board 913 have the second structural form. The first structural form refers to a semi-cured adhesive film, and the second structural form refers to complete curing. To reduce the Young's modulus, the second sub-board is made of a dielectric material that is not reinforced by a continuously-encoded fiber cloth. For descriptions of the dielectric material of the second sub-board, refer to the dielectric material shown in the foregoing embodiments that is used to pare the second sub-board. For example, for the second sub-board, a Df is less than or equal to 0.002, a Young's modulus is less than or equal to 5 GPa, a CTE in the target plane XY is less than or equal to 35 ppm/°C, and a Dk is less than or equal to 3.5. Preferably, the thickness is less than or equal to 50 µm.

For performance of the circuit board shown in this embodiment, refer to Table 8.

**Table 8**

| | First sub-board | | | Third sub-board | | | Second sub-board | | | PCB result | |
|---|---|---|---|---|---|---|---|---|---|---|---|
| | CTE/ ppm/ °C in the target plane XY | Young's modulus/ GPa | Thic kness /µm | CTE/ ppm/ °C in the target plane XY | Young's modulus/ GPa | Thickne ss/µm | CTE/ ppm/ °C in the target plane XY | Young's modulus /GPa | Thickn ess/µm | CTE/ ppm/ °C in the target plane XY | Young's modulus /GPa |
| Example 1 | 8 | 30 | 400 | 15 | 20 | 100 | 35 | 2 | 50 | 20.7 | 14.5 |
| Example 2 | 8 | 30 | 400 | 15 | 20 | 100 | 30 | 2 | 50 | 20.7 | 14.3 |
| Example 3 | 8 | 30 | 400 | 15 | 20 | 100 | 25 | 2 | 50 | 20.7 | 14.1 |

The circuit board shown in Table 8 includes three examples. In Example 1, for the first sub-board of the circuit board, the CTE in the target plane XY is 8, the Young's modulus is 30 GPa, and the thickness is 400 µm. For the third sub-board, the CTE in the target plane XY is 15, the Young's modulus is 20, and the thickness is 100 µm. For second sub-board, the CTE in the target plane XY is 35, the Young's modulus is 2, and the thickness is 50 µm. In Example 1, for the entire circuit board, the CTE in the target plane XY is 20.7, and the Young's modulus is 14.5. In Example 2, for the first sub-board of the circuit board, the CTE in the target plane XY is 8, the Young's modulus is 30, and the thickness is 400 µm. For the third sub-board, the CTE in the target plane XY is 15, the Young's modulus is 20, and the thickness is 100 µm. For second sub-board, the CTE in the target plane XY is 30, the Young's modulus is 2, and the thickness is 50 µm. In Example 2, for the entire circuit board, the CTE in the target plane XY is 20.7, and the Young's modulus is 14.3. In Example 3, for the first sub-board of the circuit board, the CTE in the target plane XY is 8, the Young's modulus is 30, and the thickness is 400 µm. For the third sub-board, the CTE in the target plane XY is 15, the Young's modulus is 20, and the thickness is 100 µm. For second sub-board, the CTE in the target plane XY is 25, the Young's modulus is 2, and the thickness is 50 µm. In Example 3, for the entire circuit board, the CTE in the target plane XY is 20.7, and the Young's modulus is 14.1.

For performance of the existing circuit board, refer to Table 9.

**Table 9**

| | First sub-board | | | Second sub-board | | | PCB result | |
|---|---|---|---|---|---|---|---|---|
| | CTE in the target plane XY | Young's modulus | Thickness/ µm | CTE in the target plane XY | Young's modulus | Thickness/ µm | CTE in the target plane XY | Young's modulus |
| Existing circuit board | 8 | 30 | 200 | 15 | 20 | 100 | 26.2 | 14.9 |

For descriptions of a structure of the existing circuit board, refer to the descriptions corresponding to FIG. 2. Details are not described again. It may be understood that, for the first sub-board of the existing circuit board, the CTE in the target plane XY is 8, the Young's modulus is 30, and the thickness is 200 µm. For the second sub-board, the CTE in the target plane XY is 15, the Young's modulus is 20, and the thickness is 100. For the entire existing circuit board, the CTE in the target plane XY is 26.2, and the Young's modulus is 14.9. It can be learned from comparison between Table 8 and Table 9 that, the structure of the circuit board in this embodiment can effectively reduce the CTE of the entire circuit board in the target plane XY, and can ensure that the Young's modulus of the circuit board is close to the Young's modulus of the existing circuit board. It may be understood that the circuit board shown in this embodiment can meet both requirements of a low CTE and a high Young's modulus of the circuit board.

An embodiment of this application further provides a circuit board. The circuit board may be a PCB or a substrate. For specific descriptions, refer to any embodiment shown in FIG. 3, FIG. 4, FIG. 6, FIG. 7, FIG. 8, or FIG. 9. Details are not described again.

An embodiment of this application further provides a communication system. The communication system includes at least two connected communication devices. For specific descriptions of the communication device, refer to any embodiment shown in FIG. 1, FIG. 3, FIG. 4, FIG. 6, FIG. 7, FIG. 8, or FIG. 9. Details are not described again.

An embodiment of this application further provides a chip. For descriptions of the chip, refer to the descriptions corresponding to FIG. 1. Details are not described again.

The foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A circuit board, wherein in a direction perpendicular to a surface of the circuit board, the circuit board comprises M sub-boards that are sequentially arranged, M is any integer not less than 2, the M sub-boards comprise a first sub-board and a second sub-board, a coefficient of thermal expansion of the first sub-board is less than a coefficient of thermal expansion of the second sub-board, and a dielectric dissipation factor of the second sub-board is less than a dielectric dissipation factor of the first sub-board.

2. The circuit board according to claim 1, wherein a Young's modulus of the second sub-board is less than a Young's modulus of the first sub-board.

3. The circuit board according to claim 1 or 2, wherein the M sub-boards comprise a plurality of second sub-boards, and the plurality of second sub-boards are symmetrically distributed by using the first sub-board as a center.

4. The circuit board according to any one of claims 1 to 3, wherein the M sub-boards further comprise a third sub-board, and the second sub-board is located between the first sub-board and the second sub-board; and
a coefficient of thermal expansion of the third sub-board is less than the coefficient of thermal expansion of the second sub-board, and the dielectric dissipation factor of the second sub-board is less than a dielectric dissipation factor of the third sub-board.

5. The circuit board according to claim 4, wherein the Young's modulus of the second sub-board is less than a Young's modulus of the third sub-board.

6. The circuit board according to claim 4 or 5, wherein the M sub-boards comprise a plurality of third sub-boards, and the plurality of third sub-boards are symmetrically distributed by using the first sub-board as a center.

7. The circuit board according to any one of claims 4 to 6, wherein in a target plane, the coefficient of thermal expansion of the first sub-board is less than the coefficient of thermal expansion of the second sub-board, and the coefficient of thermal expansion of the third sub-board is less than the coefficient of thermal expansion of the second sub-board, wherein the target plane is parallel to the surface of the circuit board.

8. The circuit board according to any one of claims 4 to 7, wherein a thickness of the first sub-board in a target direction is greater than a thickness of the second sub-board in the target direction, and the thickness of the first sub-board in the target direction is greater than a thickness of the third sub-board in the target direction, wherein the target direction is a direction perpendicular to the surface of the circuit board.

9. The circuit board according to any one of claims 4 to 8, wherein the M sub-boards comprise a fourth sub-board, and in the direction perpendicular to the surface of the circuit board, the fourth sub-board is located between the first sub-board and the second sub-board; and
a coefficient of thermal expansion of the fourth sub-board is less than the coefficient of thermal expansion of the second sub-board, and the dielectric dissipation factor of the second sub-board is less than a dielectric dissipation factor of the fourth sub-board.

10. The circuit board according to claim 9, wherein the Young's modulus of the second sub-board is less than a Young's modulus of the fourth sub-board.

11. The circuit board according to any one of claims 1 to 10, wherein the second sub-board comprises a first dielectric layer, the coefficient of thermal expansion of the first sub-board is less than a coefficient of thermal expansion of the first dielectric layer, and a dielectric dissipation factor of the first dielectric layer is less than the dielectric dissipation factor of the first sub-board; and
the second sub-board further comprises a second dielectric layer, wherein in the direction perpendicular to the surface of the circuit board, the first dielectric layer comprises a first surface and a second surface that are opposite to each other, the second dielectric layer is located on the first surface, and/or the second dielectric layer is located on the second surface, and a dielectric material of the second dielectric layer is different from a dielectric material of the first dielectric layer.

12. The circuit board according to claim 11, wherein the first dielectric layer and the second dielectric layer satisfy at least one of the following conditions:
a dielectric dissipation factor of the second dielectric layer is less than the dielectric dissipation factor of the first dielectric layer, a Young's modulus of the second dielectric layer is greater than a Young's modulus of the first dielectric layer, and a coefficient of thermal expansion of the second dielectric layer is less than the coefficient of thermal expansion of the first dielectric layer.

13. A communication device, comprising a circuit board and an electronic component connected to the circuit board, wherein the circuit board is the circuit board according to any one of claims 1 to 12.

14. A chip, wherein the chip comprises a package housing, the package housing comprises a circuit board and a die connected to the circuit board, and the circuit board is the circuit board according to any one of claims 1 to 12.
